# EUROPEAN PATENT APPLICATION

(11) **EP 4 651 685 A1**
(43) Date of publication of application: **19.11.2025**
(21) Application number: 24909207.3
(22) Date of filing: 31.12.2024
(51) Int. Cl.: H10K 30/50

(54) **SOLAR CELL AND MANUFACTURING METHOD THEREFOR, AND PHOTOVOLTAIC MODULE**

(30) Priority: 29.03.2024 CN 202410382634
(71) Applicant: LONGi Green Energy Technology Co., Ltd., Xi'an, Shaanxi 710100 (CN)
(72) Inventor: TONG, Hongbo, Xi'an, Shaanxi 710100 (CN); LIU, Qingping, Xi'an, Shaanxi 710100 (CN); DONG, Guangbin, Xi'an, Shaanxi 710100 (CN); DING, Chao, Xi'an, Shaanxi 710100 (CN); ZHANG, Hongchao, Xi'an, Shaanxi 710100 (CN); CHEN, Chen, Xi'an, Shaanxi 710100 (CN); XU, Xinxing, Xi'an, Shaanxi 710100 (CN); WANG, Yanzeng, Xi'an, Shaanxi 710100 (CN)
(74) Representative: Pfenning, Meinig & Partner mbB
(86) International application number: PCT/CN2024/144523
(87) International publication number: WO 2025/200691

(57) **Abstract**

The present application provides implementations relating to a solar cell, a preparation method therefor, and a photovoltaic module, and relates to the field of photovoltaic technologies. In an implementation, a solar cell includes a silicon substrate, a front-side passivation anti-reflection layer located on a light-facing side of the silicon substrate, and a back-side passivation anti-reflection layer located on a back side of the silicon substrate. The silicon substrate includes a light-facing surface and a back surface. The light-facing surface of the silicon substrate includes a first textured structure. At least a part of regions of the back surface of the silicon substrate includes a second textured structure. Apex angles of the second textured structure are greater than apex angles of the first textured structure. The present application not only ensures that passivation performance of each position of the solar cell matches an actual passivation requirement, but also ensures that anti-reflection performance of each position matches an actual anti-reflection requirement, so that performance of the solar cell is improved, and the solar cell has a more uniform black appearance and is more beautiful. In addition, a material waste can be reduced.

## Description

### CROSS-REFERENCE TO RELATED APPLICATIONS

This application is a 371 national stage application of PCT Application No. PCT/CN2024/144523, filed on December 31, 2024, which claims priority to Chinese Patent Application No. 202410382634.1, filed on March 29, 2024. The disclosures of the aforementioned applications are hereby incorporated by reference in their entireties.

### TECHNICAL FIELD

The present application relates to the field of photovoltaic technologies, and in particular, to a solar cell, a preparation method therefor, and a photovoltaic module.

### BACKGROUND

Solar cells can convert solar energy into electric energy, and utilize clean energy, so that the solar cells have a wide application prospect.

In the solar cells, functional film layers such as a passivation anti-reflection layer are usually disposed on a light-facing side and a back side for both a passivation effect and a good anti-reflection effect, to improve a short-circuit current and the like.

However, in an existing solar cell, different passivation effects and anti-reflection effects required by textured structures at different positions are not considered. As a result, a passivation film is thick and affects light absorption, or the passivation film is thin and affects the passivation effect, and consequently, performance of the solar cell is affected.

### SUMMARY

The present application provides a solar cell, a preparation method therefor, and a photovoltaic module, and intends to resolve a problem that it is difficult to achieve a balance between a passivation effect and an anti-reflection effect in a solar cell when a textured structure is considered.

According to a first aspect of the present application, a solar cell is provided, including:
a silicon substrate, a front-side passivation anti-reflection layer located on a light-facing side of the silicon substrate, and a back-side passivation anti-reflection layer located on a back side of the silicon substrate.

The silicon substrate includes a light-facing surface and a back surface. The light-facing surface of the silicon substrate includes a first textured structure. At least a part of regions of the back surface of the silicon substrate includes a second textured structure. The apex angles of the second textured structure are greater than apex angles of the first textured structure.

In the present application, a requirement of the light-facing surface of the solar cell for anti-reflection is greater than a requirement of the back surface for anti-reflection. The apex angles of the first textured structure on the light-facing surface of the silicon substrate are less than the apex angles of the second textured structures in at least the part of the regions of the back surface of the silicon substrate, in other words, the first textured structure are sharper, so that the first textured structure has a larger specific surface area, in other words, the light-facing surface of the silicon substrate has a lower reflectivity and a better light trapping effect. Therefore, a short-circuit current can be improved, and a photoelectric conversion efficiency of the solar cell is finally improved. In addition, an appearance of the solar cell is uniform black, and is more beautiful. A requirement of the light-facing surface of the solar cell for passivation is lower than a requirement of the back surface for passivation, so that the apex angles of the second textured structures on the back surface of the silicon substrate are larger, that is, the second textured structures on the back surface of the silicon substrate is flatter, to help prepare to obtain the thick back-side passivation anti-reflection layer, thereby achieving a good passivation effect. Therefore, on one hand, the solar cell in the present application can ensure that passivation performance of each position matches an actual passivation requirement, and anti-reflection performance of each position matches an actual anti-reflection requirement, so that not only a passivation effect and an anti-reflection effect are better, but also a material waste is reduced. On the other hand, the first textured structure and the second textured structure can improve light absorption and have a better light trapping effect, so that the short-circuit current can be further improved, and the photoelectric conversion efficiency of the solar cell is further improved. In addition, the appearance of the solar cell is uniform black, and is more beautiful. In conclusion, the present application not only ensures that the passivation performance of each position of the solar cell matches the actual passivation requirement, but also ensures that the anti-reflection performance of each position matches the actual anti-reflection requirement, so that performance of the solar cell is improved, and the solar cell has the more uniform black appearance and is more beautiful. In addition, the material waste can be reduced.

In an embodiment, the apex angles of the second textured structure are greater than or equal to 79°, and the apex angles of the first textured structure are less than 79°.

In an embodiment, an average apex angle of the second textured structure is greater than or equal to 85°, and an average apex angle of the first textured structure is less than 75°.

In an embodiment, an absolute value of a largest difference between apex angles of adjacent first textured structures on the light-facing surface of the silicon substrate is greater than an absolute value of a largest difference between apex angles of adjacent second textured structures on the back surface of the silicon substrate. When a difference between the apex angles of the adjacent second textured structures on the back surface of the silicon substrate is smaller, distribution of the textured structure in the region is more uniform, deposition on a film layer is better facilitated, and a better passivation effect is achieved.

In an embodiment, the first textured structure includes a plurality of first quasi-pyramid structures, and each of the first quasi-pyramid structures includes a pyramid surface and a pyramid vertex. The second textured structure includes a plurality of second quasi-pyramid structures, and each of the second quasi-pyramid structures includes a pyramid surface and a pyramid vertex.

In an embodiment, a surface fluctuation of the pyramid surface of the first quasi-pyramid structure is greater than a surface fluctuation of the pyramid surface of the second quasi-pyramid structure.

Alternatively, a roughness of the pyramid surface of the first quasi-pyramid structure is greater than a roughness of the pyramid surface of the second quasi-pyramid structure. A larger surface fluctuation/roughness of a pyramid surface of a quasi-pyramid structure indicates a better light trapping effect of the pyramid surface, but is adverse to uniformity of deposition on a passivation anti-reflection layer, and negatively affects a passivation effect. Therefore, the first quasi-pyramid structure with the larger surface fluctuation/roughness is disposed on the light-facing surface, to satisfy a requirement of the light-facing surface for light trapping and anti-reflection. In addition, the front-side passivation anti-reflection layer on the light-facing surface more carries an anti-reflection function. Therefore, the front-side passivation anti-reflection layer on the light-facing surface does not need to have the large thickness of the back-side passivation anti-reflection layer on the back surface. The surface fluctuation/roughness of the second quasi-pyramid structure is small, so that the deposited back-side passivation anti-reflection layer is more uniform, and a back-side passivation film layer prepared by using a same film-layer preparation process is thicker, to satisfy a requirement for back-side passivation.

In an embodiment, a surface fluctuation of a first sub-pyramid surface that is close to the pyramid vertex of the first quasi-pyramid structure and that is on the pyramid surface of the first quasi-pyramid structure is greater than a surface fluctuation of a second sub-pyramid surface that is close to the pyramid vertex of the second quasi-pyramid structure and that is on the pyramid surface of the second quasi-pyramid structure.

Alternatively, a roughness of the first sub-pyramid surface is greater than a roughness of the second sub-pyramid surface.

In an embodiment, the first quasi-pyramid structure includes a lower portion and an upper portion. The lower portion is a portion away from the pyramid vertex in the first quasi-pyramid structure. A height of the lower portion is at least 1/10 of a height of the first quasi-pyramid structure. The first sub-pyramid surface is a region corresponding to the upper portion on the pyramid surface of the first quasi-pyramid structure.

The second quasi-pyramid structure includes a lower portion and an upper portion. The lower portion is a portion away from the pyramid vertex in the second quasi-pyramid structure. A height of the lower portion is at least 1/10 of a height of the second quasi-pyramid structure. The second sub-pyramid surface is a region corresponding to the upper portion on the pyramid surface of the second quasi-pyramid structure. For a single quasi-pyramid structure, in the silicon substrate, a portion adjacent to the quasi-pyramid structure is complex, and usually has many defects. A position at which neighboring quasi-pyramid structures are adjacent is also complex, and usually also has many defects. Therefore, these positions need thick passivation anti-reflection layers to achieve a good passivation effect. However, the pyramid vertex usually has few defects, and only needs a thin passivation anti-reflection layer to achieve a good passivation effect. However, a portion of the quasi-pyramid structure that is close to the pyramid vertex has a larger surface fluctuation/roughness, and thicknesses of passivation anti-reflection layers obtained through deposition are different. After light enters the passivation anti-reflection layers with different thicknesses, a light path of the light changes more times, so that light absorption can be further improved, and a light trapping effect is better in cooperation with the textured structure of the present application. The light-facing surface and the back surface have different requirements for passivation and anti-reflection, so that requirements on the surface fluctuation/roughness of the portion of the single quasi-pyramid structure that is close to the pyramid vertex are different, and the surface fluctuation/roughness of the portion of the single quasi-pyramid structure that is close to the pyramid vertex is larger on the light-facing surface.

In an embodiment, the first quasi-pyramid structure further includes a bottom outline away from the pyramid vertex, and a width of the first quasi-pyramid structure is a maximum inner size of the bottom outline of the first quasi-pyramid structure.

The second quasi-pyramid structure further includes a bottom outline away from the pyramid vertex, and a width of the second quasi-pyramid structure is a maximum inner size of the bottom outline of the second quasi-pyramid structure.

A ratio of a height of the first quasi-pyramid structure to the width of the first quasi-pyramid structure is greater than a ratio of a height of the second quasi-pyramid structure to the width of the second quasi-pyramid structure.

In an embodiment, the pyramid surface of the first quasi-pyramid structure and the pyramid surface of the second quasi-pyramid structure have branched textures, and a quantity of branched textures on the pyramid surface of the first quasi-pyramid structure is greater than a quantity of branched textures on the pyramid surface of the second quasi-pyramid structure.

Alternatively, the pyramid surface of the first quasi-pyramid structure has branched textures, and the pyramid surface of the second quasi-pyramid structure does not have branched textures. When there are more textures on the pyramid surface, the pyramid surface is less flat, and a light trapping effect and an anti-reflection effect are better.

In an embodiment, the front-side passivation anti-reflection layer includes a first part located in the first textured structure, and the back-side passivation anti-reflection layer includes a second part located in the second textured structure.

A thickness of the first part is less than a thickness of the second part.

In an embodiment, the back surface of the silicon substrate has a non-textured structure, and the back-side passivation anti-reflection layer includes a second part located in the second textured structure and a third part located in the non-textured structure.

A thickness of the second part is less than a thickness of the third part.

In an embodiment, the front-side passivation anti-reflection layer includes a first part located in the first textured structure. The back surface of the silicon substrate has a non-textured structure. The back-side passivation anti-reflection layer includes a second part located in the second textured structure and a third part located in the non-textured structure.

A thickness of the first part is smaller than a thickness of the second part, and the thickness of the second part is smaller than a thickness of the third part.

In an embodiment, the front-side passivation anti-reflection layer includes a first part located in the first textured structure, and the back-side passivation anti-reflection layer includes a second part located in the second textured structure.

An unevenness of a thickness of the first part is greater than an unevenness of a thickness of the second part.

The unevenness of the thickness of the first part is: in parts located in a same first quasi-pyramid structure at the front-side passivation anti-reflection layer, an absolute value of a difference between two thicknesses at two positions in a same direction toward a pyramid vertex of the first quasi-pyramid structure divided by a sum of the two thicknesses.

The unevenness of the thickness of the second part is: in parts located in a same second quasi-pyramid structure at the back-side passivation anti-reflection layer, an absolute value of a difference between two thicknesses at two positions in a same direction toward a pyramid vertex of the second quasi-pyramid structure divided by a sum of the two thicknesses. When an unevenness of a thickness of a passivation anti-reflection layer is larger, a light path of a light changes more times after the light enters the passivation anti-reflection layers with different thicknesses, so that an optical path length can be increased, and both light absorption and a light trapping effect can be improved in cooperation with the textured structure.

In an embodiment, a difference between a thickness of a part located in the second textured structure at the back-side passivation anti-reflection layer and a thickness of the front-side passivation anti-reflection layer is greater than or equal to 15 nm and less than or equal to 50 nm at two opposite positions in a thickness direction of the silicon substrate.

In an embodiment, the back surface of the silicon substrate includes first regions and second regions that are alternately distributed and isolated by isolation regions.

The solar cell further includes first conductive layers located in the first regions and second conductive layers located in the second regions. A conductivity type of the first conductive layers is different from a conductivity type of the second conductive layers.

At least one of the first regions, the second regions, and the isolation regions have the second textured structure on the back surface of the silicon substrate.

In an embodiment, a width of the isolation region ranges from 50 µm to 350 µm, and a direction of the width of the isolation region is parallel to a direction in which the first regions and the second regions are alternately distributed.

In an embodiment, the back surface of the silicon substrate includes first regions and second regions that are alternately distributed. The solar cell further includes first conductive layers located in the first regions. First conductive elements are doped at the first conductive layers. Second conductive elements are doped in at least a part of the second regions. A conductivity type of the first conductive elements is different from a conductivity type of the second conductive elements. Intersections of the second regions and the first regions have the second textured structure.

In an embodiment, the solar cell further includes: a first conductive layer located between the silicon substrate and the front-side passivation anti-reflection layer, and a second conductive layer located between the silicon substrate and the back-side passivation anti-reflection layer. A conductivity type of the first conductive layer is different from a conductivity type of the second conductive layer.

The back surface of the silicon substrate has the second textured structure.

According to a second aspect of the present application, a photovoltaic module is provided, including a plurality of solar cells in any one of the foregoing descriptions.

According to a third aspect of the present application, a preparation method for a solar cell is provided. The method includes:
providing a silicon substrate, where the silicon substrate includes a light-facing surface and a back surface;
performing texturing on the silicon substrate to form a first textured structure on the light-facing surface of the silicon substrate and a second textured structure in at least a part of regions of the back surface of the silicon substrate, where apex angles of the second textured structure are greater than apex angles of the first textured structure;
preparing a front-side passivation anti-reflection layer on a light-facing side of the silicon substrate; and
preparing a back-side passivation anti-reflection layer on a back side of the silicon substrate.

In an embodiment, the performing texturing on the silicon substrate includes:
separately performing texturing on the light-facing surface and the back surface of the silicon substrate, to enable texturing duration of at least the part of the regions of the back surface of the silicon substrate to be shorter than texturing duration of the light-facing surface of the silicon substrate; and/or
disposing a texturing protective layer in at least the part of the regions of the back surface of the silicon substrate, and performing texturing on the silicon substrate, where texturing duration of at least the part of the regions of the back surface of the silicon substrate is shorter than texturing duration of the light-facing surface of the silicon substrate under a blocking effect of the texturing protective layer; and/or
obliquely disposing the silicon substrate in texturing liquid, where the light-facing surface of the silicon substrate is closer to a liquid surface of the texturing liquid than the back surface at two opposite positions in a thickness direction of the silicon substrate, and performing texturing on the silicon substrate.

In an embodiment, a difference between the texturing duration of the light-facing surface of the silicon substrate and the texturing duration of at least the part of the regions of the back surface of the silicon substrate ranges from 30 seconds to 200 seconds.

In an embodiment, the back surface of the silicon substrate includes first regions and second regions that are alternately distributed and isolated by isolation regions. Before the disposing a texturing protective layer in at least the part of the regions of the back surface of the silicon substrate, the method further includes:
performing polishing processing on the silicon substrate;
preparing an entire first conductive layer on the back surface of the silicon substrate;
performing pattering processing on parts that are at the first conductive layer and that are located in the second region and the isolation region, to expose the second region and the isolation region; and
preparing second conductive layers in the second region, the isolation region, and the remaining of the first conductive layer, where a conductivity type of the first conductive layer is different from a conductivity type of the second conductive layers.

The disposing a texturing protective layer in at least the part of the regions of the back surface of the silicon substrate includes:
performing laser processing on parts that are at the second conductive layer and that are located in the first region and the isolation region, to oxidize the parts that are at the second conductive layer and that are located in the first region and the isolation region into the texturing protective layer.

The performing texturing on the silicon substrate, where texturing duration of at least the part of the regions of the back surface of the silicon substrate is shorter than texturing duration of the light-facing surface of the silicon substrate under a blocking effect of the texturing protective layer, to form a first textured structure on the light-facing surface of the silicon substrate and a second textured structure in at least a part of regions of the back surface of the silicon substrate includes:
performing texturing on the silicon substrate, to form the first textured structure on the light-facing surface of the silicon substrate, removing the texturing protective layer by using the texturing liquid, to expose the isolation region and the first conductive layer, and then performing texturing on the isolation region by using the texturing liquid, to form the second textured structure in the isolation region on the back surface of the silicon substrate.

In an embodiment, in the laser processing:
the laser includes one of nanosecond laser, picosecond laser, and femtosecond laser; and/or a laser power ranges from 10 W to 100 W; and/or
a diameter of a light spot of the laser ranges from 50 µm to 350 µm.

In an embodiment, the silicon substrate is disposed in the texturing liquid, and an angle between the thickness direction of the silicon substrate and the liquid surface of the texturing liquid ranges from 3° to 7°.

The present application not only ensures that passivation performance of each position of the solar cell matches an actual passivation requirement, but also ensures that anti-reflection performance of each position matches an actual anti-reflection requirement, so that performance of the solar cell is improved, and the solar cell has a more uniform black appearance and is more beautiful. In addition, a material waste can be reduced.

### BRIEF DESCRIPTION OF THE DRAWINGS

To describe the technical solutions in embodiments of the present application more clearly, the following briefly describes the accompanying drawings required for describing the embodiments of the present application. Apparently, the accompanying drawings in the following description show merely some embodiments of the present application, and a person of ordinary skill in the art may still derive other accompanying drawings from these accompanying drawings without creative efforts.
FIG. 1 is a schematic diagram of a structure of a solar cell according to an embodiment of the present application;
FIG. 2 is a scanning electron microscope diagram of a front view of a light-facing surface of a first type of silicon substrate according to an embodiment of the present application;
FIG. 3 is a scanning electron microscope diagram of a front view of a light-facing surface of a second type of silicon substrate according to an embodiment of the present application;
FIG. 4 is a scanning electron microscope diagram of a front view of a light-facing surface of a third type of silicon substrate according to an embodiment of the present application;
FIG. 5 is a scanning electron microscope diagram of a front view of a light-facing surface of a fourth type of silicon substrate according to an embodiment of the present application;
FIG. 6 is a scanning electron microscope diagram of a top view of a light-facing surface of a silicon substrate according to an embodiment of the present application;
FIG. 7 is a scanning electron microscope diagram of a front view of a back surface of a first type of silicon substrate according to an embodiment of the present application;
FIG. 8 is a scanning electron microscope diagram of a front view of a back surface of a second type of silicon substrate according to an embodiment of the present application;
FIG. 9 is a scanning electron microscope diagram of a front view of a back surface of a third type of silicon substrate according to an embodiment of the present application;
FIG. 10 is a scanning electron microscope diagram of a bottom view of a back surface of a silicon substrate according to an embodiment of the present application; and
FIG. 11 to FIG. 16 are schematic flowcharts of parts of a preparation procedure of a solar cell according to an embodiment of the present application.

Reference numerals:
1-silicon substrate, 11-pyramid vertex, 12-branched textures, 13-bottom outline, 2-front-side passivation anti-reflection layer, 3-back-side passivation anti-reflection layer, 4-first conductive layer, 5-second conductive layer, 6-first electrode, 7-second electrode, 8-tunneling oxide layer, 9-laser effect region, 10-texturing protective layer, and 14-wrap-around polysilicon.

### DETAILED DESCRIPTION

The following clearly and completely describes the technical solutions in embodiments of the present application with reference to the accompanying drawings in the embodiments of the present application. It is clear that the described embodiments are a part but not all of embodiments of the present application. All other embodiments obtained by a person of ordinary skill in the art based on the embodiments of the present application without creative efforts shall fall within the protection scope of the present application.

In an existing solar cell, it is difficult to achieve a balance between a passivation effect and an anti-reflection effect. A main reason that performance of the solar cell is affected lies in that, when a thickness of a passivation anti-reflection layer is increased, a passivation effect of the passivation anti-reflection layer is better, but an anti-reflection effect is properly reduced. As a result, it is difficult to achieve a balance between the passivation effect and the anti-reflection effect. More specifically, in the existing solar cell, a front side and a back side usually have textured structures with a same size, and passivation anti-reflection layers with approximately equal thicknesses are formed on the textured structures with the same size, in other words, the front side and the back side have approximately same passivation anti-reflection performance. However, it is clear that a requirement of a light-facing surface of the solar cell on anti-reflection is different from a requirement of a back surface on anti-reflection, and a requirement of the light-facing surface of the solar cell on passivation is different from a requirement of the back surface on passivation, in other words, in the existing solar cell, the passivation anti-reflection performance of the front side and the back side does not match actual passivation anti-reflection requirements of the front side and the back side, affecting the performance of the solar cell. For the foregoing technical problem, a main conception of the present application lies in properly setting a textured structure based on requirements of a light-facing surface of a solar cell on passivation and anti-reflection and requirements of a back surface of the solar cell on passivation and anti-reflection, so that passivation and anti-reflection performance of a front side and a back side in the solar cell matches actual passivation and anti-reflection requirements of the front side and the back side, to improve performance of the solar cell. More specifically, in the present application, a requirement of the light-facing surface of the solar cell for anti-reflection is greater than a requirement of the back surface for anti-reflection. The apex angles of the first textured structure on the light-facing surface of the silicon substrate are less than the apex angles of the second textured structures in at least the part of the regions of the back surface of the silicon substrate, in other words, the first textured structure are sharper, so that the first textured structure has a larger specific surface area, in other words, the light-facing surface of the silicon substrate has a lower reflectivity and a better light trapping effect. Therefore, a short-circuit current can be improved, and a photoelectric conversion efficiency of the solar cell is finally improved. In addition, an appearance of the solar cell is uniform black, and is more beautiful. A requirement of the light-facing surface of the solar cell for passivation is lower than a requirement of the back surface for passivation, so that the apex angles of the second textured structures on the back surface of the silicon substrate are larger, that is, the second textured structures on the back surface of the silicon substrate is flatter, to help prepare to obtain the thick back-side passivation anti-reflection layer, thereby achieving a good passivation effect. Therefore, on one hand, the solar cell in the present application can ensure that passivation performance of each position matches an actual passivation requirement, and anti-reflection performance of each position matches an actual anti-reflection requirement, so that not only a passivation effect and an anti-reflection effect are better, but also a material waste is reduced. On the other hand, the first textured structure and the second textured structure can improve light absorption and have a better light trapping effect, so that the short-circuit current can be further improved, and the photoelectric conversion efficiency of the solar cell is further improved. In addition, the appearance of the solar cell is uniform black, and is more beautiful. In conclusion, the present application not only ensures that the passivation performance of each position of the solar cell matches the actual passivation requirement, but also ensures that the anti-reflection performance of each position matches the actual anti-reflection requirement, so that performance of the solar cell is improved, and the solar cell has the more uniform black appearance and is more beautiful. In addition, the material waste can be reduced.

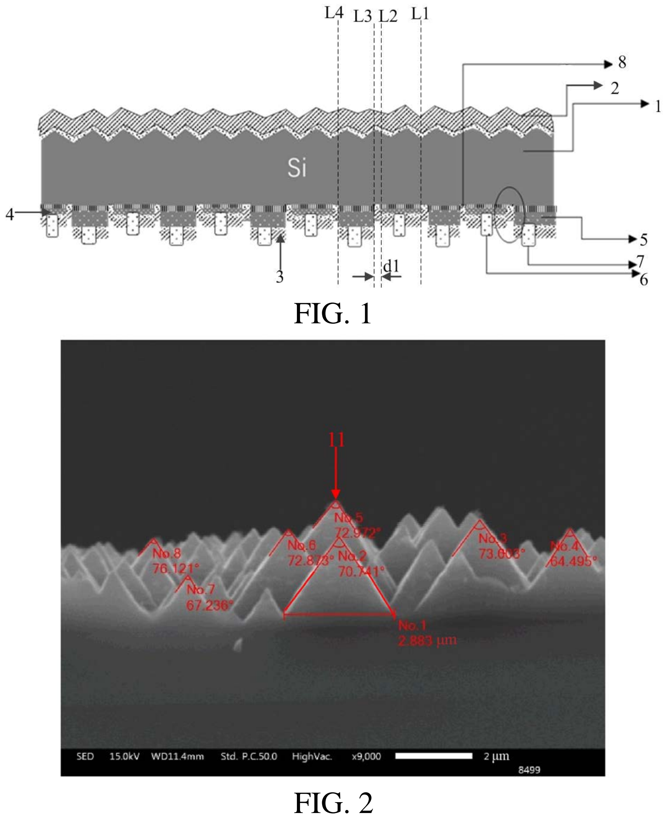

The present application provides a solar cell. Referring to FIG. 1, the solar cell may include a silicon substrate 1, a front-side passivation anti-reflection layer 2 located on a light-facing side of the silicon substrate 1, and a back-side passivation anti-reflection layer 3 located on a back side of the silicon substrate. In FIG. 1, an upper side of the silicon substrate 1 may be the light-facing side thereof, a lower side is the back side thereof, an upper surface of the silicon substrate 1 is a light-facing surface thereof, and a lower surface is a back surface thereof. The silicon substrate 1 may be doped or intrinsic. This is not specifically limited. The silicon substrate 1 may be a monocrystalline silicon substrate or the like. This is also not specifically limited. The passivation anti-reflection layer herein may have both a passivation effect and an anti-reflection effect. A material of the passivation anti-reflection layer may be selected as silicon oxide and/or silicon oxynitride. The specific material of the passivation anti-reflection layer is not limited. The passivation anti-reflection layer may be prepared by using a manner such as PECVD (plasma-enhanced chemical vapor deposition). A specific manner of preparing the passivation anti-reflection layer is also not specifically limited.

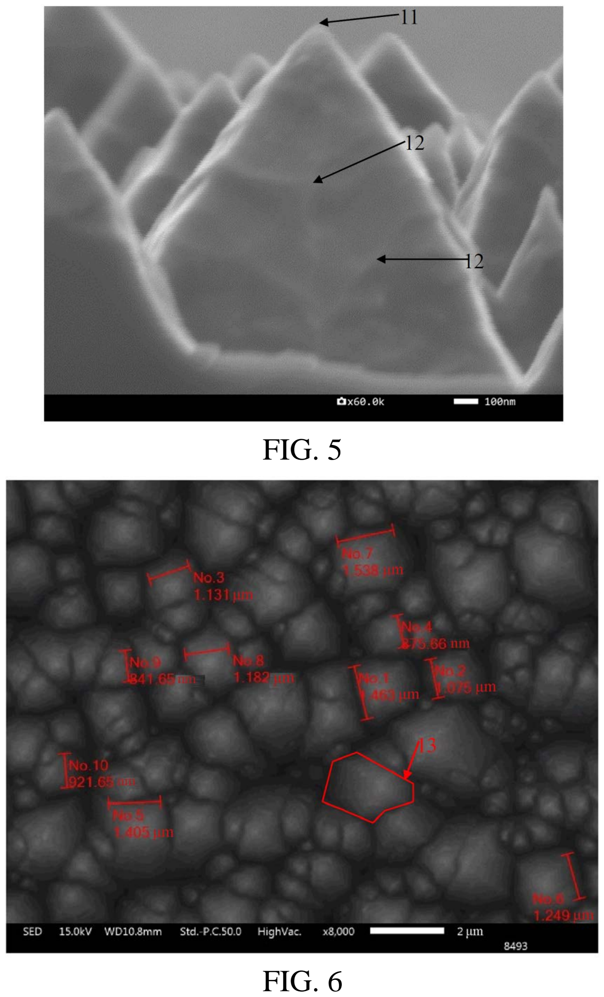

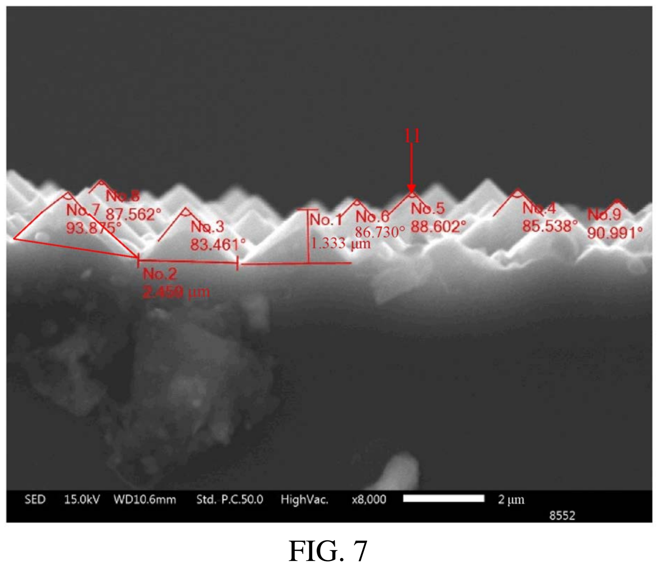

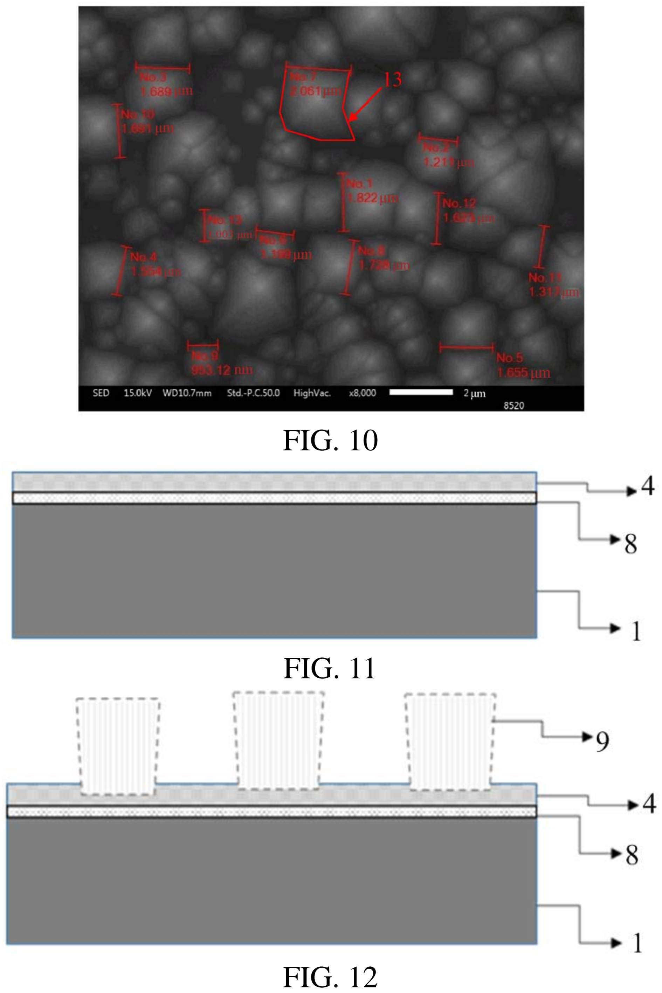

FIG. 2 to FIG. 5 are all mainly scanning electron microscope diagrams obtained by scanning a first textured structure from a front view or a side view. FIG. 6 is mainly a scanning electron microscope diagram obtained by scanning a first textured structure in a direction from a pyramid vertex to a bottom outline. FIG. 7 to FIG. 9 are all mainly scanning electron microscope diagrams obtained by scanning a second textured structure from a front view or a side view. FIG. 10 is mainly a scanning electron microscope diagram obtained by scanning a second textured structure in a direction from a pyramid vertex to a bottom outline. FIG. 1 and FIG. 11 to FIG. 16 only represent relative position relationships of layers of structures in a solar cell, but do not represent relative size relationships of actual sizes thereof.

Referring to FIG. 2 to FIG. 6 and FIG. 16, the light-facing surface of the silicon substrate 1 includes a first textured structure. Referring to FIG. 7 to FIG. 10 and FIG. 16, at least a part of regions of the back surface of the silicon substrate 1 includes a second textured structure. Referring to FIG. 2 to FIG. 10, apex angles of the second textured structure are greater than apex angles of the first textured structure. As shown in FIG. 2, FIG. 3, and FIG. 4, the apex angles of the first textured structure are apex angles of a cross section of the first textured structure, and may be measured by using a scanning electron microscope SEM. As shown in FIG. 7, FIG. 8, and FIG. 9, the apex angles of the second textured structure are apex angles of a cross section of the second textured structure, and may be measured by using a scanning electron microscope SEM. A pyramid vertex 11 is a highest point in a first quasi-pyramid structure or a second quasi-pyramid structure. When a highest portion of the first quasi-pyramid structure or the second quasi-pyramid structure is a plane including a plurality of points having equal heights, the pyramid vertex herein may be a geometric center of the plane. A side edge of the quasi-pyramid structure may be a common edge of adjacent side surfaces in the quasi-pyramid structure. When the apex angles of the first textured structure are smaller, in other words, the first textured structure are sharper, the first textured structure has a larger specific surface area, in other words, the light-facing surface of the silicon substrate 1 has a lower reflectivity and a better light trapping effect. Therefore, a short-circuit current can be improved, and a photoelectric conversion efficiency of the solar cell is finally improved. In addition, an appearance of the solar cell is uniform black, and is more beautiful. A requirement of the light-facing surface of the solar cell for passivation is lower than a requirement of the back surface for passivation, so that the apex angles of the second textured structures on the back surface of the silicon substrate 1 are larger, that is, the second textured structures on the back surface of the silicon substrate 1 is flatter, to help prepare to obtain the thick back-side passivation anti-reflection layer, thereby achieving a good passivation effect. Therefore, on one hand, the solar cell in the present application can ensure that passivation performance of each position matches an actual passivation requirement, and anti-reflection performance of each position matches an actual anti-reflection requirement, so that not only a passivation effect and an anti-reflection effect are better, but also a material waste is reduced. On the other hand, the first textured structure and the second textured structure can improve light absorption and have a better light trapping effect, so that the short-circuit current can be further improved, and the photoelectric conversion efficiency of the solar cell is further improved. In addition, the appearance of the solar cell is uniform black, and is more beautiful. In conclusion, the present application not only ensures that the passivation performance of each position of the solar cell matches the actual passivation requirement, but also ensures that the anti-reflection performance of each position matches the actual anti-reflection requirement, so that performance of the solar cell is improved, and the solar cell has the more uniform black appearance and is more beautiful. In addition, the material waste can be reduced.

It should be noted that, when the apex angles of the second textured structure are greater than the apex angles of the first textured structure, a difference between the apex angles is not specifically limited. In the present application, that the apex angles of the second textured structure are greater than the apex angles of the first textured structure may be understood as that each of all the apex angles of the second textured structure is greater than each of all the apex angles of the first textured structure. Alternatively, that the apex angles of the second textured structure are greater than the apex angles of the first textured structure may be understood as that each apex angle in a first preset proportion of a total quantity of all the apex angles of the second textured structure is greater than each apex angle in a second preset proportion of a total quantity of all the apex angles of the first textured structure. The first preset proportion and the second preset proportion herein may both be greater than or equal to 50%, and the first preset proportion and the second preset proportion may be equal or not equal. This is not specifically limited. For example, each apex angle in 50% of the total quantity of all the apex angles of the second textured structure is greater than each apex angle in 50% of the total quantity of all the apex angles of the first textured structure. For example, each apex angle in 55% of the total quantity of all the apex angles of the second textured structure is greater than each apex angle in 55% of the total quantity of all the apex angles of the first textured structure. For another example, each apex angle in 60% of the total quantity of all the apex angles of the second textured structure is greater than each apex angle in 60% of the total quantity of all the apex angles of the first textured structure. For another example, each apex angle in 65% of the total quantity of all the apex angles of the second textured structure is greater than each apex angle in 65% of the total quantity of all the apex angles of the first textured structure. For another example, each apex angle in 70% of the total quantity of all the apex angles of the second textured structure is greater than each apex angle in 70% of the total quantity of all the apex angles of the first textured structure. For another example, each apex angle in 75% of the total quantity of all the apex angles of the second textured structure is greater than each apex angle in 75% of the total quantity of all the apex angles of the first textured structure. For another example, each apex angle in 80% of the total quantity of all the apex angles of the second textured structure is greater than each apex angle in 80% of the total quantity of all the apex angles of the first textured structure. For another example, each apex angle in 85% of the total quantity of all the apex angles of the second textured structure is greater than each apex angle in 85% of the total quantity of all the apex angles of the first textured structure. For another example, each apex angle in 90% of the total quantity of all the apex angles of the second textured structure is greater than each apex angle in 90% of the total quantity of all the apex angles of the first textured structure. For another example, each apex angle in 95% of the total quantity of all the apex angles of the second textured structure is greater than each apex angle in 95% of the total quantity of all the apex angles of the first textured structure. For another example, each apex angle in 99.3% of the total quantity of all the apex angles of the second textured structure is greater than each apex angle in 99% of the total quantity of all the apex angles of the first textured structure. For another example, each apex angle in 50% of the total quantity of all the apex angles of the second textured structure is greater than each apex angle in 53% of the total quantity of all the apex angles of the first textured structure. For another example, each apex angle in 60% of the total quantity of all the apex angles of the second textured structure is greater than each apex angle in 55% of the total quantity of all the apex angles of the first textured structure. For another example, each apex angle in 83% of the total quantity of all the apex angles of the second textured structure is greater than each apex angle in 85% of the total quantity of all the apex angles of the first textured structure. For another example, each apex angle in 97% of the total quantity of all the apex angles of the second textured structure is greater than each apex angle in 96.2% of the total quantity of all the apex angles of the first textured structure.

It should be noted that the total quantity of all the apex angles of the first textured structure and the total quantity of all the apex angles of the second textured structure may be equal or not equal. This is not specifically limited. Whether a quantity of the first preset proportion of the total quantity of all the apex angles of the second textured structure is equal to a quantity of the second preset proportion of the total quantity of all the apex angles of the first textured structure is not specifically limited, and the two quantities may be equal or not equal. Whether all the regions of the light-facing surface of the silicon substrate 1 herein include the first textured structure or only a part of the regions of the light-facing surface of the silicon substrate include the first textured structure is not specifically limited. Whether all the regions of the back surface of the silicon substrate 1 herein include the second textured structure or only a part of the regions of the back surface of the silicon substrate 1 includes the second textured structure is not specifically limited.

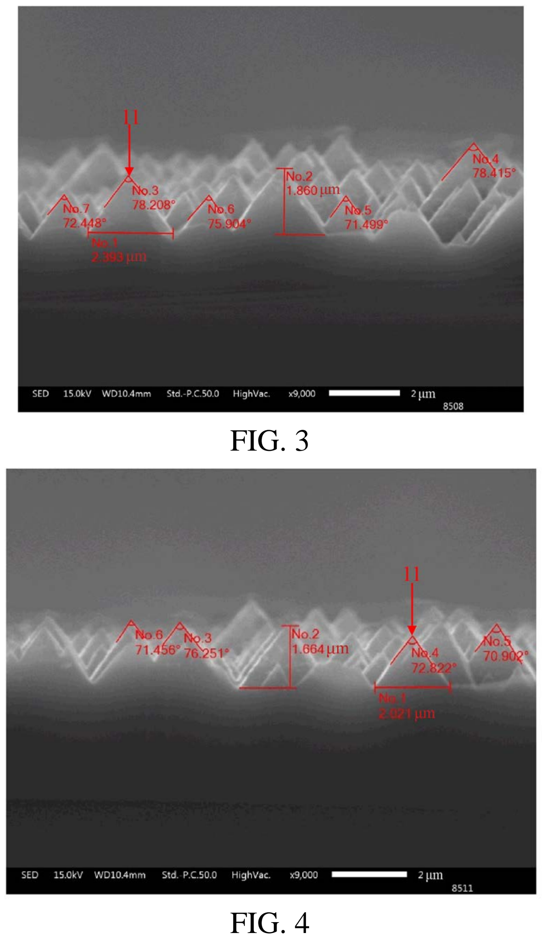

In an embodiment, referring to FIG. 2 to FIG. 4, the apex angles of the first textured structure are less than 79°. When the apex angles of the first textured structure are smaller, the first textured structure are sharper, so that the first textured structure has a larger specific surface area, in other words, the light-facing surface of the silicon substrate 1 has a lower reflectivity and a better light trapping effect. Therefore, the short-circuit current can be improved, and the photoelectric conversion efficiency of the solar cell is finally improved. In addition, the appearance of the solar cell is uniform black, and is more beautiful. In addition, a thickness of the front-side passivation anti-reflection layer prepared in the first textured structure is proper, so that a passivation requirement of the light-facing surface of the silicon substrate 1 can be satisfied, and the material waste can be avoided. In the accompanying drawings, No is an abbreviation of a number. For example, in FIG. 2, apex angles numbered from 2 to 8 through marking in the first textured structure are respectively 70.741°, 73.603°, 64.495°, 72.972°, 72.873°, 67.236°, and 76.121°, and the seven apex angles are all less than 79°. For another example, in FIG. 3, apex angles numbered from 3 to 7 through marking in the first textured structure are respectively 78.208°, 78.415°, 71.499°, 75.904°, and 72.448°, and the five apex angles are all less than 79°. For another example, in FIG. 4, apex angles numbered from 3 to 6 through marking in the first textured structure are respectively 76.251°, 72.822°, 70.902°, and 71.456°, and the four apex angles are all less than 79°.

That the apex angles of the first textured structure are less than 79° may refer to that each of all the apex angles of the first textured structure is less than 79°, or may refer to that each apex angle in a third preset proportion of a total quantity of all the apex angles of the first textured structure is less than 79°. The third preset proportion herein may be greater than or equal to 50%.

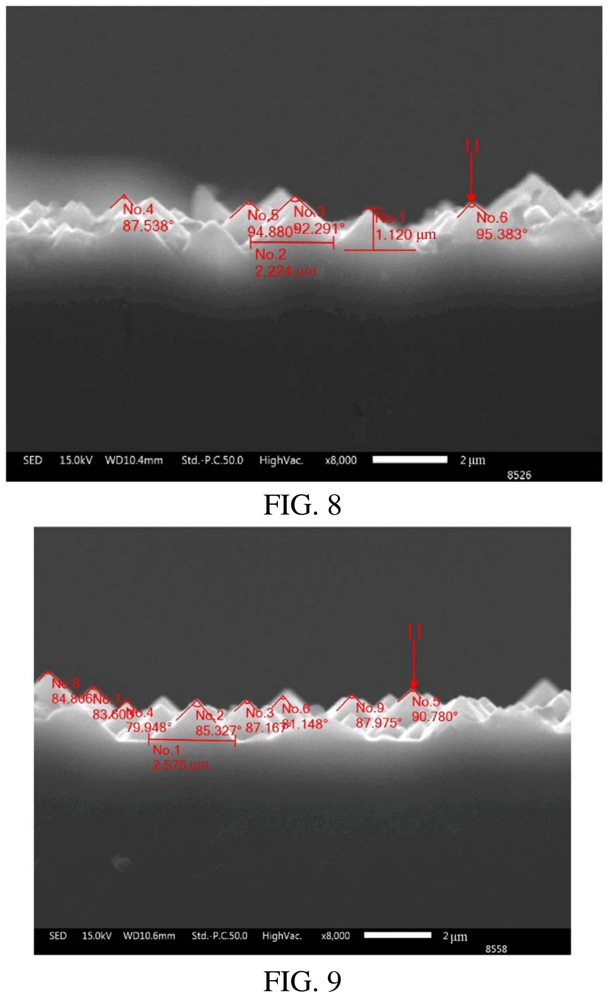

In an embodiment, referring to FIG. 7 to FIG. 9, the apex angles of the second textured structure are greater than or equal to 79°, so that the apex angles of the second textured structures on the back surface of the silicon substrate 1 are larger, that is, the second textured structures on the back surface of the silicon substrate 1 is flatter, to help prepare to obtain the thick back-side passivation anti-reflection layer, thereby achieving a good passivation effect. For example, in FIG. 7, apex angles numbered from 3 to 9 through marking in the second textured structure are respectively 83.461°, 85.538°, 88.602°, 86.730°, 93.875°, 87.562°, and 90.991°, and the seven apex angles are all greater than 79°. For another example, in FIG. 8, apex angles numbered from 3 to 6 through marking in the second textured structure are respectively 92.291°, 87.538°, 94.880°, and 95.383°, and the four apex angles are all greater than 79°. For another example, in FIG. 9, apex angles numbered from 2 to 9 through marking in the second textured structure are respectively 85.327°, 87.167°, 79.948°, 90.780°, 81.148°, 83.600°, 84.806°, and 87.975°, and the eight apex angles are all greater than 79°.

That the apex angles of the second textured structure are greater than or equal to 79° may refer to that each of all the apex angles of the second textured structure is greater than or equal to 79°, or may refer to that each apex angle in a fourth preset proportion of a total quantity of all the apex angles of the second textured structure is greater than or equal to 79°. The fourth preset proportion herein may be greater than or equal to 50%.

In an embodiment, referring to FIG. 7 to FIG. 9, an average apex angle of the second textured structure is greater than or equal to 85°, so that the apex angles of the second textured structures on the back surface of the silicon substrate 1 are all larger, that is, the second textured structures on the back surface of the silicon substrate 1 is flatter, to help prepare to obtain the thick back-side passivation anti-reflection layer, thereby achieving a good passivation effect. The average apex angle of the second textured structure is an arithmetic mean of all the apex angles of the second textured structure, or may be an arithmetic mean of apex angles of a fifth preset proportion of a total quantity of all the apex angles of the second textured structure. The fifth preset proportion herein may be greater than or equal to 50%.

For example, the average apex angle of the second textured structure may be 85°, 85.53°, 88.6°, 86.73°, 87.875°, 87.61°, 93.875°, 87.22°, 90.9°, or 94.275°.

In an embodiment, referring to FIG. 2 to FIG. 5, an average apex angle of the first textured structure is less than 75°. When the apex angles of the first textured structure are all smaller, the first textured structure are sharper, so that the first textured structure has a larger specific surface area, in other words, the light-facing surface of the silicon substrate 1 has a lower reflectivity and a better light trapping effect. Therefore, the short-circuit current can be improved, and the photoelectric conversion efficiency of the solar cell is finally improved. In addition, the appearance of the solar cell is uniform black, and is more beautiful. In addition, the thickness of the front-side passivation anti-reflection layer prepared in the first textured structure is proper, so that the passivation requirement of the light-facing surface of the silicon substrate 1 can be satisfied, and the material waste can be avoided. The average apex angle of the first textured structure is an arithmetic mean of all the apex angles of the first textured structure, or may be an arithmetic mean of apex angles of a sixth preset proportion of a total quantity of all the apex angles of the first textured structure. The sixth preset proportion herein may be greater than or equal to 50%.

For example, the average apex angle of the first textured structure may be 74.99°, 74.5°, 74.02°, 73.59°, 73.11°, 72.5°, 72.01°, 71.49°, 71.23°, 70.69°, or 70.04°.

In an embodiment, an absolute value of a largest difference between apex angles of adjacent first textured structures on the light-facing surface of the silicon substrate 1 is greater than an absolute value of a largest difference between apex angles of adjacent second textured structures on the back surface of the silicon substrate 1. A uniformity degree of the apex angles of the first textured structure is less than a uniformity degree of the apex angles of the second textured structure. The apex angles of the first textured structure are less uniform, and the difference between the apex angles of the first textured structure is larger, so that the first textured structure has a larger specific surface area, in other words, the light-facing surface of the silicon substrate 1 has a lower reflectivity and a better light trapping effect. Therefore, the short-circuit current can be improved, and the photoelectric conversion efficiency of the solar cell is finally improved. In addition, the appearance of the solar cell is uniform black, and is more beautiful. In addition, the thickness of the front-side passivation anti-reflection layer prepared in the first textured structure is proper, so that the passivation requirement of the light-facing surface of the silicon substrate 1 can be satisfied, and the material waste can be avoided. The apex angles of the second textured structure are more uniform, to help prepare to obtain the thick back-side passivation anti-reflection layer with a uniform thickness, thereby achieving a good passivation effect. The apex angles of the adjacent first textured structures on the light-facing surface of the silicon substrate 1 are two closest apex angles in the first textured structure on the light-facing surface of the silicon substrate 1. The absolute value of the largest difference between the apex angles of the adjacent first textured structures on the light-facing surface of the silicon substrate 1 refers to: selecting apex angles of a first preset quantity of pairs of adjacent first textured structures from the light-facing surface of the silicon substrate 1, performing subtraction on apex angles of two adjacent first textured structures in the apex angles of the first preset quantity of pairs of adjacent first textured structures, to obtain the first preset quantity of differences, and selecting the largest absolute value from absolute values of the first preset quantity of differences. The apex angles of the adjacent second textured structures on the back surface of the silicon substrate 1 are two closest apex angles in the second textured structure on the back surface of the silicon substrate 1. The absolute value of the largest difference between the apex angles of the adjacent second textured structures on the back surface of the silicon substrate 1 refers to: selecting apex angles of a second preset quantity of pairs of adjacent second textured structures from the back surface of the silicon substrate 1, performing subtraction on apex angles of two adjacent second textured structures in the apex angles of the second preset quantity of pairs of adjacent second textured structures, to obtain the second preset quantity of differences, and selecting the largest absolute value from absolute values of the second preset quantity of differences.

It should be noted that whether the first preset quantity and the second preset quantity herein are equal is not limited, and the first preset quantity and the second preset quantity may be equal or not equal. Both the first preset quantity and the second preset quantity herein may be selected based on an actual requirement. For example, both the first preset quantity and the second preset quantity may be greater than or equal to 3. For another example, both the first preset quantity and the second preset quantity may be greater than or equal to 5. A difference between the absolute value of the largest difference between the apex angles of the adjacent first textured structures on the light-facing surface of the silicon substrate 1 and the absolute value of the largest difference between the apex angles of the adjacent second textured structures on the back surface of the silicon substrate 1 is not specifically limited.

In an embodiment, referring to FIG. 2 to FIG. 6, the first textured structure includes a plurality of first quasi-pyramid structures, for example, a first quasi-pyramid structure indicated by red lines in FIG. 2. Each of the first quasi-pyramid structures includes a pyramid surface and a pyramid vertex 11. In an embodiment, referring to FIG. 7 to FIG. 9, the second textured structure includes a plurality of second quasi-pyramid structures, for example, a second quasi-pyramid structure indicated by red lines in FIG. 7. Each of the second quasi-pyramid structures includes a pyramid surface and a pyramid vertex 11. For a definition of the pyramid vertex 11, refer to the foregoing descriptions, and details are not described herein again. In the first quasi-pyramid structure, the pyramid surface of the first quasi-pyramid structure is a set of all side surfaces of the first quasi-pyramid structure, that is, all surfaces of the first quasi-pyramid structure except a bottom surface and the pyramid vertex 11. The pyramid surface of the first quasi-pyramid structure connects the pyramid vertex 11 and a bottom outline of the first quasi-pyramid structure. The bottom outline is a lowest outline of the first quasi-pyramid structure. In the second quasi-pyramid structure, the pyramid surface of the second quasi-pyramid structure is a set of all side surfaces of the second quasi-pyramid structure, that is, all surfaces of the second quasi-pyramid structure except a bottom surface and the pyramid vertex 11. The pyramid surface of the second quasi-pyramid structure connects the pyramid vertex 11 and a bottom outline of the second quasi-pyramid structure. The bottom outline is a lowest outline of the second quasi-pyramid structure.

A surface fluctuation mainly refers to a degree of surface fluctuation caused by high and low structures on a surface, and a roughness refers to a degree of unevenness caused by a slight protrusion/slight recess on a surface. In an embodiment, a surface fluctuation of the pyramid surface of the first quasi-pyramid structure is greater than a surface fluctuation of the pyramid surface of the second quasi-pyramid structure, or a roughness of the pyramid surface of the first quasi-pyramid structure is greater than a roughness of the pyramid surface of the second quasi-pyramid structure. In one case, a quantity of protrusions and/or recesses on the pyramid surface of the first quasi-pyramid structure may be greater than a quantity of protrusions and/or recesses on the pyramid surface of the second quasi-pyramid structure. In another case, a degree of protrusions and/or recesses on the pyramid surface of the first quasi-pyramid structure may be greater than a degree of protrusions and/or recesses on the pyramid surface of the second quasi-pyramid structure. In another case, arrangement of protrusions and/or recesses on the pyramid surface of the first quasi-pyramid structure may be more disordered than arrangement of protrusions and/or recesses on the pyramid surface of the second quasi-pyramid structure. In another case, a height of protrusions and/or a depth of recesses on the pyramid surface of the first quasi-pyramid structure may be greater than a height of protrusions and/or a depth of recesses on the pyramid surface of the second quasi-pyramid structure. Further, a shape of the pyramid surface of the first quasi-pyramid structure is more irregular, so that the first textured structure has a larger specific surface area, a lower reflectivity, and a better light trapping effect. Therefore, the short-circuit current can be improved, and the photoelectric conversion efficiency of the solar cell is finally improved. In addition, the appearance of the solar cell is uniform black, and is more beautiful.

In an embodiment, a surface fluctuation of a first sub-pyramid surface that is close to the pyramid vertex 11 of the first quasi-pyramid structure and that is on the pyramid surface of the first quasi-pyramid structure is greater than a surface fluctuation of a second sub-pyramid surface that is close to the pyramid vertex 11 of the second quasi-pyramid structure and that is on the pyramid surface of the second quasi-pyramid structure, or a roughness of the first sub-pyramid surface is greater than a roughness of the second sub-pyramid surface. In other words, a shape of the upper sub-pyramid surface that is close to the pyramid vertex 11 of the first quasi-pyramid structure and that is on the pyramid surface of the first quasi-pyramid structure is more irregular than a shape of the upper sub-pyramid surface that is close to the pyramid vertex 11 of the second quasi-pyramid structure and that is on the pyramid surface of the second quasi-pyramid structure. Specifically, anti-reflection performance of a portion of the light-facing surface of the silicon substrate 1 close to the pyramid vertex 11 is better, and contributes more to improvement of the photoelectric conversion efficiency of the solar cell. Therefore, in the present application, through the foregoing adjustment, the first textured structure has a larger specific surface area, a lower reflectivity, and a better light trapping effect. Therefore, the short-circuit current can be improved, and the photoelectric conversion efficiency of the solar cell is finally improved. In addition, the appearance of the solar cell is uniform black, and is more beautiful. In one case, a quantity of protrusions and/or recesses on the first sub-pyramid surface that is close to the pyramid vertex of the first quasi-pyramid structure and that is on the pyramid surface of the first quasi-pyramid structure may be greater than a quantity of protrusions and/or recesses on the second sub-pyramid surface that is close to the pyramid vertex of the second quasi-pyramid structure and that is on the pyramid surface of the second quasi-pyramid structure. In another case, a degree of protrusions and/or recesses on the first sub-pyramid surface that is close to the pyramid vertex of the first quasi-pyramid structure and that is on the pyramid surface of the first quasi-pyramid structure may be greater than a degree of protrusions and/or recesses on the second sub-pyramid surface that is close to the pyramid vertex of the second quasi-pyramid structure and that is on the pyramid surface of the second quasi-pyramid structure. In another case, arrangement of protrusions and/or recesses on the first sub-pyramid surface that is close to the pyramid vertex of the first quasi-pyramid structure and that is on the pyramid surface of the first quasi-pyramid structure may be more disordered than arrangement of protrusions and/or recesses on the second sub-pyramid surface that is close to the pyramid vertex of the second quasi-pyramid structure and that is on the pyramid surface of the second quasi-pyramid structure. In another case, a height of protrusions and/or a depth of recesses on the first sub-pyramid surface that is close to the pyramid vertex of the first quasi-pyramid structure and that is on the pyramid surface of the first quasi-pyramid structure may be greater than a height of protrusions and/or a depth of recesses on the second sub-pyramid surface that is close to the pyramid vertex of the second quasi-pyramid structure and that is on the pyramid surface of the second quasi-pyramid structure.

In an embodiment, referring to FIG. 2 to FIG. 6, the first quasi-pyramid structure includes a lower portion and an upper portion. The lower portion is a portion away from the pyramid vertex 11 in the first quasi-pyramid structure, and the upper portion is a portion close to the pyramid vertex 11 in the first quasi-pyramid structure and the pyramid vertex, or a portion other than the lower portion in the first quasi-pyramid structure. A height of the lower portion is at least 1/10 of a height of the first quasi-pyramid structure. The first sub-pyramid surface that is close to the pyramid vertex of the first quasi-pyramid structure and that is on the pyramid surface of the first quasi-pyramid structure is a region corresponding to the upper portion on the pyramid surface of the first quasi-pyramid structure. In an embodiment, referring to FIG. 7 to FIG. 10, the second quasi-pyramid structure includes a lower portion and an upper portion. The lower portion is a portion away from the pyramid vertex 11 in the second quasi-pyramid structure, and the upper portion is a portion close to the pyramid vertex 11 in the second quasi-pyramid structure and the pyramid vertex, or a portion other than the lower portion in the second quasi-pyramid structure. A height of the lower portion is at least 1/10 of a height of the second quasi-pyramid structure. The second sub-pyramid surface is a region corresponding to the upper portion on the pyramid surface of the second quasi-pyramid structure. Specifically, the second sub-pyramid surface and the first sub-pyramid surface are accurately divided, to help ensure that the lower portion of the quasi-pyramid structure occupies a particular proportion in a process of preparing the first textured structure and the second textured structure, so that a requirement of the lower portion of the quasi-pyramid structure on passivation is ensured. The upper portion and the lower portion of the quasi-pyramid structure each occupy a particular proportion, and different morphologies are set, so that a light trapping effect of the upper portion is better, and a passivation effect of the lower portion is better. A surface fluctuation/roughness of the morphology of the pyramid surface of the upper portion of the first quasi-pyramid structure or the second quasi-pyramid structure is large, so that the upper portion of the first quasi-pyramid structure or the second quasi-pyramid structure has a lower reflectivity and a better light trapping effect. Therefore, the short-circuit current can be improved, and the photoelectric conversion efficiency of the solar cell is finally improved. In addition, the appearance of the solar cell is uniform black, and is more beautiful. The morphology of the pyramid surface of the lower portion of the first quasi-pyramid structure or the second quasi-pyramid structure is flat, to help prepare to obtain the thick back-side passivation anti-reflection layer, thereby achieving a good passivation effect. In this specification, for a proportion of the height of the lower portion of the quasi-pyramid structure, it should be understood that, the foregoing effect can be achieved provided that heights of lower portions of most quasi-pyramid structures in the textured structure satisfy the foregoing proportion. For a single quasi-pyramid structure, in the silicon substrate, a portion adjacent to the quasi-pyramid structure is complex, and usually has many defects (such as a hole or a recombination center on a surface). A position at which neighboring quasi-pyramid structures are adjacent is also complex, and usually also has many defects (such as a hole or a recombination center on a surface. Therefore, these positions away from the pyramid vertex (such as a lower portion of the quasi-pyramid structure) need thick passivation anti-reflection layers to achieve a good passivation effect, but these positions have low requirements on anti-reflection. However, the pyramid vertex or a position close to the pyramid vertex (such as an upper portion of the quasi-pyramid structure) usually has few defects, and therefore only needs a thin passivation anti-reflection layer to achieve a good passivation effect, but these positions have high requirements on anti-reflection. When a portion of the quasi-pyramid structure that is close to the pyramid vertex has a larger surface fluctuation/roughness, on one hand, this portion of the structure has a lower reflectivity and a better light trapping effect, on the other hand, thicknesses of passivation anti-reflection layers obtained through deposition in this portion are different. After light enters the passivation anti-reflection layers with different thicknesses, a light path of the light changes more times, so that light absorption can be further improved, and a light trapping effect is better in cooperation with the textured structure of the present application. A portion of the quasi-pyramid structure that is away from the pyramid vertex is flat, to help prepare to obtain the thick back-side passivation anti-reflection layer, thereby achieving a good passivation effect. In addition, the light-facing surface and the back surface have different requirements for passivation and anti-reflection, so that requirements on the surface fluctuation/roughness of the portion of the single quasi-pyramid structure that is close to the pyramid vertex are different, and the surface fluctuation/roughness of the portion of the single quasi-pyramid structure that is close to the pyramid vertex is larger on the light-facing surface.

For example, the portion away from the pyramid vertex 11 in the first quasi-pyramid structure is the lower portion of the first quasi-pyramid structure, and the height of the lower portion is 1/10, 2/15, 3/20, 1/9, 1/8, 1/7, 1/6, 1/5, or 1/4 of the height of the first quasi-pyramid structure. The first quasi-pyramid structure includes the upper portion and the lower portion. The first sub-pyramid surface that is close to the pyramid vertex 11 of the first quasi-pyramid structure and that is on the pyramid surface of the first quasi-pyramid structure is the region corresponding to the upper portion on the pyramid surface of the first quasi-pyramid structure.

For example, the portion away from the pyramid vertex 11 in the second quasi-pyramid structure is the lower portion of the second quasi-pyramid structure, and the height of the lower portion is 1/10, 2/15, 3/20, 1/9, 1/8, 1/7, 1/6, 1/5, or 1/4 of the height of the second quasi-pyramid structure. The second quasi-pyramid structure includes the upper portion and the lower portion. The second sub-pyramid surface that is close to the pyramid vertex 11 of the second quasi-pyramid structure and that is on the pyramid surface of the second quasi-pyramid structure is the region corresponding to the upper portion on the pyramid surface of the second quasi-pyramid structure.

In an embodiment, the first quasi-pyramid structure includes a lower portion and an upper portion. The lower portion is a portion away from the pyramid vertex 11 in the first quasi-pyramid structure. A height of the lower portion is at least 1/5 of a height of the first quasi-pyramid structure. The first sub-pyramid surface that is close to the pyramid vertex 11 of the first quasi-pyramid structure and that is on the pyramid surface of the first quasi-pyramid structure is a region corresponding to the upper portion on the pyramid surface of the first quasi-pyramid structure. The second quasi-pyramid structure includes a lower portion and an upper portion. The lower portion is a portion away from the pyramid vertex 11 in the second quasi-pyramid structure. A height of the lower portion is at least 1/5 of a height of the second quasi-pyramid structure. The second sub-pyramid surface that is close to the pyramid vertex 11 of the second quasi-pyramid structure and that is on the pyramid surface of the second quasi-pyramid structure is a region corresponding to the upper portion on the pyramid surface of the second quasi-pyramid structure. The technical effect that can be achieved by accurately dividing the first sub-pyramid surface and the second sub-pyramid surface is described above.

For example, the first quasi-pyramid structure includes the lower portion and the upper portion. The lower portion of the first quasi-pyramid structure is the portion away from the pyramid vertex 11 in the first quasi-pyramid structure. The height of the lower portion is 1/5, 1/4, 3/10, 2/5, 1/3, 1/2, or 3/5 of the height of the first quasi-pyramid structure.

For example, the second quasi-pyramid structure includes the lower portion and the upper portion. The lower portion of the second quasi-pyramid structure is the portion away from the pyramid vertex 11 in the second quasi-pyramid structure. The height of the lower portion is 1/5, 1/4, 3/10, 2/5, 1/3, 1/2, or 3/5 of the height of the second quasi-pyramid structure.

In an embodiment, referring to FIG. 6, the first quasi-pyramid structure further includes a bottom outline 13 away from the pyramid vertex. Referring to FIG. 2 to FIG. 4 and FIG. 6, a width of the first quasi-pyramid structure is a maximum inner size of the bottom outline 13 of the first quasi-pyramid structure. Referring to FIG. 10, the second quasi-pyramid structure further includes a bottom outline 13 away from the pyramid vertex. Referring to FIG. 7 to FIG. 10, a width of the second quasi-pyramid structure is a maximum inner size of the bottom outline 13 of the second quasi-pyramid structure. A ratio of a height of the first quasi-pyramid structure to the width of the first quasi-pyramid structure is greater than a ratio of a height of the second quasi-pyramid structure to the width of the second quasi-pyramid structure. In other words, the first quasi-pyramid structure has a larger aspect ratio, and the first textured structure are sharper, so that the first textured structure has a larger specific surface area, in other words, the light-facing surface of the silicon substrate 1 has a lower reflectivity and a better light trapping effect. Therefore, the short-circuit current can be improved, and the photoelectric conversion efficiency of the solar cell is finally improved. In addition, the appearance of the solar cell is uniform black, and is more beautiful. In addition, the thickness of the front-side passivation anti-reflection layer prepared in the first textured structure is proper, so that the passivation requirement of the light-facing surface of the silicon substrate 1 can be satisfied, and the material waste can be avoided. The second quasi-pyramid structure has a smaller aspect ratio, and the second textured structure is flatter, to help prepare to obtain the thick back-side passivation anti-reflection layer, thereby achieving a good passivation effect.

That the ratio of the height of the first quasi-pyramid structure to the width of the first quasi-pyramid structure is greater than the ratio of the height of the second quasi-pyramid structure to the width of the second quasi-pyramid structure may refer to that ratios of heights of all first quasi-pyramid structures of the first textured structure to corresponding widths of the first quasi-pyramid structures are all greater than ratios of heights of all second quasi-pyramid structures of the second textured structure to corresponding widths of the second quasi-pyramid structures. Alternatively, that the ratio of the height of the first quasi-pyramid structure to the width of the first quasi-pyramid structure is greater than the ratio of the height of the second quasi-pyramid structure to the width of the second quasi-pyramid structure may refer to that ratios of heights of first quasi-pyramid structures of a seventh preset proportion of a total quantity of all the quasi-pyramid structures of the first textured structure to corresponding widths of the first quasi-pyramid structures are all greater than ratios of heights of second quasi-pyramid structures of an eighth preset proportion of a total quantity of all the quasi-pyramid structures of the second textured structure to corresponding widths of the second quasi-pyramid structures. The seventh preset proportion and the eighth preset proportion herein may both be greater than or equal to 50%, and the seventh preset proportion and the eighth preset proportion may be equal or not equal.

Referring to FIG. 5, the pyramid surface of the first quasi-pyramid structure has branched textures 12. In an embodiment, the pyramid surface of the first quasi-pyramid structure and the pyramid surface of the second quasi-pyramid structure have branched textures. A quantity of branched textures on the pyramid surface of the first quasi-pyramid structure is greater than a quantity of branched textures on the pyramid surface of the second quasi-pyramid structure. Alternatively, the pyramid surface of the first quasi-pyramid structure has branched textures, and the pyramid surface of the second quasi-pyramid structure does not have branched textures. A shape of the branched textures 12 is similar to a shape of a branch. The branched textures 12 are textures with a branch on a main trunk. There is a correspondence the branched textures 12 and the protrusions or recesses on the pyramid surface of the quasi-pyramid structure. The branched textures 12 are usually located at an interface between the protrusions and the recesses on the pyramid surface of the quasi-pyramid structure. To be specific, when there are more branched textures 12, there are more protrusions and recesses on the pyramid surface of the quasi-pyramid structure, so that textures in the first quasi-pyramid structure are more, the specific surface area of the first textured structure is larger, and distribution positions of the branched textures are more irregular. Therefore, the first textured structure has a larger specific surface area, a lower reflectivity, and a better light trapping effect. Therefore, the short-circuit current can be improved, and the photoelectric conversion efficiency of the solar cell is finally improved. In addition, the appearance of the solar cell is uniform black, and is more beautiful.

In an embodiment, the front-side passivation anti-reflection layer 2 includes a first part located in the first textured structure, and the back-side passivation anti-reflection layer includes a second part located in the second textured structure. A thickness of the first part is less than a thickness of the second part. The light-facing surface of the solar cell has a high requirement on anti-reflection and a low requirement on passivation, and the first textured structure is sharper, so that the thickness of the first part located in the first textured structure at the front-side passivation anti-reflection layer 2 is smaller, and the light-facing surface of the solar cell has better anti-reflection performance and weak passivation performance, which more correspond to the anti-reflection requirement and the passivation requirement of the light-facing surface of the solar cell. Therefore, the short-circuit current can be improved, and the photoelectric conversion efficiency of the solar cell is finally improved. In addition, the appearance of the solar cell is uniform black, and is more beautiful. In addition, a waste can be avoided. The back surface of the solar cell has a low requirement on anti-reflection and a high requirement on passivation, and the second textured structure is flatter, so that the thickness of the second part located in the second textured structure at the back-side passivation anti-reflection layer 3 is larger, and the back surface of the solar cell has better passivation performance and weak anti-reflection performance, which more correspond to the anti-reflection requirement and the passivation requirement of the back surface of the solar cell. Therefore, the short-circuit current can be improved, and the photoelectric conversion efficiency of the solar cell is finally improved. In addition, the appearance of the solar cell is uniform black, and is more beautiful. In addition, a waste can be avoided. In addition, in the present application, a light path of a light changes more times after the light enters the passivation anti-reflection layers with different thicknesses, so that an optical path length can be increased. In combination with the textured structures of the present application, light absorption can be further improved, and a light trapping effect is better, so that the short-circuit current can be further improved, and the photoelectric conversion efficiency of the solar cell is further improved. In addition, the appearance of the solar cell is uniform black, and is more beautiful. A direction of the thickness herein is perpendicular to a tangent at a corresponding position on an outer surface of the passivation anti-reflection layer.

In an embodiment, the back surface of the silicon substrate 1 has a non-textured structure. The back-side passivation anti-reflection layer 3 includes a second part located in the second textured structure and a third part located in the non-textured structure. A thickness of the second part is less than a thickness of the third part. Specifically, the non-textured structure is flatter than the second textured structure, and the thick back-side passivation anti-reflection layer 3 is easily prepared. In addition, in the present application, a light path of a light changes more times after the light enters the passivation anti-reflection layers with different thicknesses, so that an optical path length can be increased. In combination with the textured structures of the present application, light absorption can be further improved, and a light trapping effect is better, so that the short-circuit current can be further improved, and the photoelectric conversion efficiency of the solar cell is further improved. In addition, the appearance of the solar cell is uniform black, and is more beautiful.

In an embodiment, a value relationship among the thickness of the first part, the thickness of the second part, and the thickness of the third part is as follows: the thickness of the third part is greater than the thickness of the second part, and the thickness of the second part is greater than the thickness of the first part, or the thickness of the second part is between the thickness of the first part and the thickness of the third part. On one hand, a good passivation effect at each position can be ensured. In addition, in the present application, a thickness of the passivation anti-reflection layer is set based on a passivation requirement, so that the material waste can be reduced. In addition, in the present application, a light path of a light changes more times after the light enters the passivation anti-reflection layers with different thicknesses, so that an optical path length can be increased. In combination with the textured structures of the present application, light absorption can be further improved, and a light trapping effect is better, so that the short-circuit current can be further improved, and the photoelectric conversion efficiency of the solar cell is further improved. In addition, the appearance of the solar cell is uniform black, and is more beautiful. In conclusion, the present application not only ensures the good passivation effect at each position of the solar cell, but also greatly improves the anti-reflection effect, and reduces the material waste.

The front-side passivation anti-reflection layer 2 includes a first part located in the first textured structure, and the back-side passivation anti-reflection layer 3 includes a second part located in the second textured structure. The unevenness of the thickness of the first part is: in parts located in a same first quasi-pyramid structure at the front-side passivation anti-reflection layer, an absolute value of a difference between two thicknesses at two positions in a same direction toward a pyramid vertex of the first quasi-pyramid structure divided by a sum of the two thicknesses. The two positions herein are any two positions in the same direction toward the pyramid vertex 11 of the first quasi-pyramid structure. For example, three first quasi-pyramid structures in the first textured structure are respectively a first quasi-pyramid structure on the left, a first quasi-pyramid structure in the middle, and a first quasi-pyramid structure on the right. In the three first quasi-pyramid structures in the first textured structure, the unevenness of the thickness of the first part may be: in a left part of a pyramid vertex in the first quasi-pyramid structure on the left in the front-side passivation anti-reflection layer 2, an absolute value of a difference between two thicknesses at two positions in a same direction toward the pyramid vertex of the first quasi-pyramid structure on the left divided by a sum of the two thicknesses. For another example, in the three first quasi-pyramid structures in the first textured structure, the unevenness of the thickness of the first part may be: in a right part of a pyramid vertex in the first quasi-pyramid structure on the left in the front-side passivation anti-reflection layer 2, an absolute value of a difference between two thicknesses at two positions in a same direction toward the pyramid vertex of the first quasi-pyramid structure on the left divided by a sum of the two thicknesses. For another example, in the three first quasi-pyramid structures in the first textured structure, the unevenness of the thickness of the first part may be: in a left part of a pyramid vertex in the first quasi-pyramid structure in the middle in the front-side passivation anti-reflection layer 2, an absolute value of a difference between two thicknesses at two positions in a same direction toward the pyramid vertex of the first quasi-pyramid structure in the middle divided by a sum of the two thicknesses. For another example, in the three first quasi-pyramid structures in the first textured structure, the unevenness of the thickness of the first part may be: in a right part of a pyramid vertex in the first quasi-pyramid structure in the middle in the front-side passivation anti-reflection layer 2, an absolute value of a difference between two thicknesses at two positions in a same direction toward the pyramid vertex of the first quasi-pyramid structure in the middle divided by a sum of the two thicknesses. For another example, in the three first quasi-pyramid structures in the first textured structure, the unevenness of the thickness of the first part may be: in a left part of a pyramid vertex in the first quasi-pyramid structure on the right in the front-side passivation anti-reflection layer 2, an absolute value of a difference between two thicknesses at two positions in a same direction toward the pyramid vertex of the first quasi-pyramid structure on the right divided by a sum of the two thicknesses. For another example, in the three first quasi-pyramid structures in the first textured structure, the unevenness of the thickness of the first part may be: in a right part of a pyramid vertex in the first quasi-pyramid structure on the right in the front-side passivation anti-reflection layer 2, an absolute value of a difference between two thicknesses at two positions in a same direction toward the pyramid vertex of the first quasi-pyramid structure on the right divided by a sum of the two thicknesses.

The unevenness of the thickness of the second part is: in parts located in a same second quasi-pyramid structure at the back-side passivation anti-reflection layer 3, an absolute value of a difference between two thicknesses at two positions in a same direction toward a pyramid vertex of the second quasi-pyramid structure divided by a sum of the two thicknesses. The two positions herein are any two positions in the same direction toward the pyramid vertex 11 of the first quasi-pyramid structure. The unevenness of the thickness of the second part herein corresponds to the examples described for the unevenness of the thickness of the first part in the three first quasi-pyramid structures in the first textured structure.

In an embodiment, the unevenness of the thickness of the first part is greater than the unevenness of the thickness of the second part. To be specific, at the back-side passivation anti-reflection layer 3, the thickness of the part in the second textured structure on the back surface of the silicon substrate 1 is more uniform, so that a good passivation effect at each position of the back surface of the silicon substrate 1 can be ensured. In addition, in the present application, a thickness of the passivation anti-reflection layer is set based on a passivation requirement, so that the material waste can be reduced.

It should be noted that, when the unevenness of the thickness of the first part is greater than the unevenness of the thickness of the second part, a difference between the two unevennesses is not specifically limited.

In an embodiment, a difference between a thickness of the back-side passivation anti-reflection layer 3 and a thickness of the front-side passivation anti-reflection layer 2 is greater than or equal to 15 nm (nanometer) and less than or equal to 50 nm at two opposite positions in a thickness direction of the silicon substrate 1. The difference between the two thicknesses are properly set, to fully ensure good passivation performance on the back side and both good passivation performance and good anti-reflection performance on the light-facing side, and a waste can be avoided.

For example, the thickness of the back-side passivation anti-reflection layer 3 may range from 85 nm to 100 nm, or be approximately 95 nm. The thickness of the front-side passivation anti-reflection layer 2 may range from 60 nm to 70 nm, or be approximately 65 nm. The difference between the thickness of the back-side passivation anti-reflection layer 3 and the thickness of the front-side passivation anti-reflection layer 2 at the two opposite positions in the thickness direction of the silicon substrate 1 may be 15 nm, 16.3 nm, 17.9 nm, 19.4 nm, 20.94 nm, 22.6 nm, 24.92 nm, 27.5 nm, 30.3 nm, 32.6 nm, 33.9 nm, 35.7 nm, 36.9 nm, 18.34 nm, 40 nm, 41.3 nm, or 50 nm.

In an embodiment, referring to FIG. 1, the back surface of the silicon substrate 1 includes first regions and second regions that are alternately distributed and isolated by isolation regions. To be specific, arrangement is repeated as: a first region, an isolation region, a second region, and then a first region, an isolation region, a second region. For example, in FIG. 1, on the back surface of the silicon substrate 1, a region between a dashed line L1 and a dashed line L2 is the first region, a region between a dashed line L3 and a dashed line L4 is the second region. In addition, the first region between the dashed line L1 and the dashed line L2 is adjacent to the second region between the dashed line L3 and the dashed line L4. An isolation region between the first region and the second region is a region between the dashed line L2 and the dashed line L3 on the back surface of the silicon substrate 1. In FIG. 1, in a part framed by an ellipse includes an isolation region. It should be noted that the dashed lines L1 to L4 in FIG. 1 do not actually exist in the solar cell, and are only examples for distinguishing the first region, the second region, and the isolation region. The solar cell further includes first conductive layers 4 located in the first regions and second conductive layers 5 located in the second regions. A conductivity type of the first conductive layers 4 is different from a conductivity type of the second conductive layers 5. One of the conductivity types of the first conductive layers 4 and the second conductive layers 5 is a p-type, and the other is an n-type. The solar cell is a back contact solar cell.

In an embodiment, at least one of the first regions, the second regions, and the isolation regions have the second textured structure on the back surface of the silicon substrate 1. When the second textured structure is disposed on the back surface of the silicon substrate 1, a reflectivity is lower, a light trapping effect is better, electricity performance of the back contact solar cell is better, and a position at which the second textured structure is disposed is more flexibly and diversified. For example, only the first region has the second textured structure. For another example, only the second region has the second textured structure. For another example, if only the isolation region has the second textured structure, both the first region and the second region are flat, and qualities of the formed film layers such as the first conductive layers 4, the second conductive layers 5, and the back-side passivation anti-reflection layer 3 are good. A conductive layer does not need to be prepared in the isolation region, and the second textured structure is disposed, so that the reflectivity is lower, the light trapping effect is better, and the electricity performance of the back contact solar cell is better. For another example, both the first region and the second region have the second textured structure. For another example, both the second region and the isolation region have the second textured structure. Both the first region and the isolation region have the second textured structure. For another example, the first region, the second region, and the isolation region all have the second textured structure.

In an embodiment, referring to FIG. 1, a width d1 of the isolation region ranges from 50 µm (micrometer) to 350 µm, and a direction of the width d1 of the isolation region is parallel to a direction in which the first regions and the second regions are alternately distributed at intervals. The width d1 of the isolation region is properly set, so that not only an insulation and isolation effect of the first conductive layers 4 and the second conductive layers 5 is good, but also space in the back contact solar cell is not wasted.

For example, the width d1 of the isolation region may be 50 µm, 52 µm, 60 µm, 63 µm, 65.4 µm, 77 µm, 100 µm, 128 µm, 176.2 µm, 150 µm, 183 µm, 200 µm, 221 µm, 250 µm, 273.1 µm, 286.4 µm, 300 µm, 307 µm, 334 µm, or 350 µm.

In an embodiment, referring to FIG. 1, the solar cell further includes first electrodes 6 located on the first conductive layers 4 and second electrodes 7 located on the second conductive layers 5. The first electrodes 6 and the second electrodes 7 are both configured to collect and conduct carriers.

In an embodiment, the back surface of the silicon substrate 1 includes first regions and second regions that are alternately distributed. To be specific, arrangement is repeated as: a first region, an isolation region, a second region, and then a first region, an isolation region, a second region. The solar cell further includes first conductive layers located in the first regions. First conductive elements are doped at the first conductive layers. Second conductive elements are doped in at least a part of the second regions. A conductivity type of the first conductive elements is different from a conductivity type of the second conductive elements. One of the conductivity types of the first conductive elements and the second conductive elements is a p-type, and the other is an n-type. The solar cell is a back contact solar cell. Intersections of the second regions and the first regions, that is, isolation regions, have the second textured structure. When the second textured structure is disposed, a back-side reflectivity is lower, a light trapping effect is better, and electricity performance of the back contact solar cell is better. The intersections of the second regions and the first regions, that is, the isolation regions, may have an insulation or isolation function. Herein, the second conductive elements may be doped in all of the second regions, or the second conductive elements are doped in a part of the second regions. This is not specifically limited. For example, the first conductive layers herein may be n-type conductive layers, the second conductive elements may be p-type conductive elements, and an aluminum back surface field may be formed by using aluminum grid lines.

In an embodiment, the solar cell is a back contact solar cell, and the back surface of the silicon substrate 1 includes first regions and second regions that are alternately distributed. First conductive layers are prepared in the first regions herein, and second conductive layers are prepared in the second regions. A conductivity type of the first conductive layers is different from a conductivity type of the second conductive layers. The first conductive layers and the second conductive layers at least partially overlap. An insulation structure is disposed in an overlapped part of the first conductive layers and the second conductive layers. At least one of the first regions and the second regions have any one of the second textured structures. In some cases, that the conductivity types are different may refer to that the conductivity types respectively include a doped p-type and a doped n-type.

In an embodiment, the solar cell is a back contact solar cell. The back surface of the silicon substrate 1 includes n-type regions and p-type regions that are alternately distributed. The n-type regions are configured to collect and conduct electrons, and there is an isolation region between an n-type region and a p-type region that are adjacent. The isolation region has any one of the second textured structures. In an embodiment, the back surface of the silicon substrate 1 includes n-type regions and p-type regions that are alternately distributed. The p-type regions have any one of the second textured structures. The light-facing surface of the silicon substrate 1 has any one of the first textured structures.

In an embodiment, the solar cell may further include: a first conductive layer located between the silicon substrate 1 and the front-side passivation anti-reflection layer, and a second conductive layer located between the silicon substrate 1 and the back-side passivation anti-reflection layer. A conductivity type of the first conductive layer is different from a conductivity type of the second conductive layer. One of the conductivity types of the two conductive layers is an n-type, and the other is a p-type. The entire back surface of the silicon substrate 1 has the second textured structure. The solar cell is a bifacial solar cell.

The present application further provides a photovoltaic module. The photovoltaic module includes a plurality of any one of the foregoing solar cells. A quantity of the solar cells in the photovoltaic module is not specifically limited. The photovoltaic module may further include encapsulation adhesive films and the like located on two sides of the solar cells. Another structure of the photovoltaic module is not specifically limited.

The present application further provides a preparation method for a solar cell. The preparation method is used to prepare any one of the foregoing solar cells. The preparation method includes the following steps.

Step 101: Provide a silicon substrate, where the silicon substrate includes a light-facing surface and a back surface.

Step 102: Perform texturing on the silicon substrate to form a first textured structure on the light-facing surface of the silicon substrate and a second textured structure in at least a part of regions of the back surface of the silicon substrate, where apex angles of the second textured structure are greater than apex angles of the first textured structure.

Texturing may be separately performed on the light-facing surface and the back surface of the silicon substrate. The first textured structure and the second textured structure may be obtained based on different texturing duration of the light-facing surface and the back surface. Alternatively, the first textured structure and the second textured structure may be obtained by adjusting compositions, a density, and/or the like of texturing liquid for separate texturing. Alternatively, a texturing result may be controlled by combining adjusting the duration and the compositions, the density, and/or the like of the texturing liquid. The texturing duration, the compositions and the density of the texturing liquid, and the like may all be adjusted and controlled. This is not specifically limited. Alternatively, the light-facing surface and the back surface of the silicon substrate may be obtained in a same texturing process, and the first textured structure and the second textured structure may be obtained by disposing a texturing protective layer, controlling a disposing manner of the silicon substrate in the texturing liquid, and/or the like.

In an embodiment, step 102 may include: separately performing texturing on the light-facing surface and the back surface of the silicon substrate, to enable texturing duration of at least the part of the regions of the back surface of the silicon substrate to be shorter than texturing duration of the light-facing surface of the silicon substrate; and/or disposing a texturing protective layer in at least the part of the regions of the back surface of the silicon substrate, and performing texturing on the silicon substrate, where texturing duration of at least the part of the regions of the back surface of the silicon substrate is shorter than texturing duration of the light-facing surface of the silicon substrate under a blocking effect of the texturing protective layer; and/or obliquely disposing the silicon substrate in texturing liquid, where the light-facing surface of the silicon substrate is closer to a liquid surface of the texturing liquid than the back surface at two opposite positions in a thickness direction of the silicon substrate, and performing texturing on the silicon substrate.

Specifically, one, two, or all of separately performing texturing, disposing the texturing protective layer, and obliquely disposing the silicon substrate may be performed. This is not specifically limited.

Differentiation of preparation of the textured surfaces on the front side and the back side may be implemented by performing controlling to enable the texturing duration of the light-facing surface of the silicon substrate to be different from the texturing duration of at least the part of the regions of the back surface of the silicon substrate. For example, the differentiation may be implemented by using the following different preparation approaches. For example, the textured surfaces on the light-facing surface and the back surface may be separately prepared. For example, the texturing protective layer that can be etched by the texturing liquid may be disposed on the back surface, and the back surface can be in contact with the silicon substrate for texturing only after the texturing protective layer is completely corroded, so that the actual texturing duration of the back surface is shorter than that of the light-facing surface. For another example, the silicon substrate may be obliquely disposed in a texturing groove, where the light-facing surface is upward and the back surface is downward. The light-facing surface of the silicon substrate is closer to the liquid surface of the texturing liquid than the back surface at the two opposite positions in the thickness direction of the silicon substrate, so that exhaust on the light-facing surface is faster than exhaust on the back surface, and the texturing liquid reacts with the silicon substrate earlier and faster to implement the differentiation of the texturing duration. Alternatively, one or a combination of the foregoing manners may be used.

For the manner of separately performing texturing, on the basis that the texturing duration of at least the part of the regions of the back surface of the silicon substrate is shorter than the texturing duration of the light-facing surface of the silicon substrate, all other texturing factors are not limited. For example, whether compositions and a density of the texturing liquid of at least the part of the regions of the back surface of the silicon substrate are the same as compositions and a density of the texturing liquid of the light-facing surface of the silicon substrate is not specifically limited. The compositions and the densities of the two types of texturing liquid herein may be the same or different. For another example, in a process of performing texturing on a surface, an angle between the thickness direction of the silicon substrate and the liquid surface of the texturing liquid is also not limited. A difference between the two texturing duration, the apex angle of the first textured structure, the apex angle of the second textured structure, and the like may be adjusted by adjusting texturing factors such as the compositions and the densities of the two types of texturing liquid, the angle between the thickness direction of the silicon substrate and the liquid surface of the texturing liquid, and the like. This is not specifically limited. In the manner of separately performing texturing, in a process of performing texturing on one of the light-facing surface and the back surface, a mask layer or the like may be disposed on the other surface.

For the manner of disposing the texturing protective layer, the texturing protective layer herein is a protective layer that can be etched by the texturing liquid. On the back side of the silicon substrate, the texturing liquid first etches the texturing protective layer, to expose at least the part of the regions of the back surface of the silicon substrate, and then texturing can be performed on at least the part of the regions of the back surface of the silicon substrate that is exposed. On the light-facing side of the silicon substrate, the light-facing surface of the silicon substrate is exposed, and the texturing liquid directly performs texturing on the light-facing surface of the silicon substrate. Therefore, the texturing duration of at least the part of the regions of the back surface of the silicon substrate is shorter than the texturing duration of the light-facing surface of the silicon substrate, to form the first textured structure on the light-facing surface of the silicon substrate and the second textured structure on at least the part of the regions of the back surface of the silicon substrate. The apex angles of the second textured structure are greater than the apex angles of the first textured structure.

For the manner of disposing the texturing protective layer, a material, a thickness, and the like of the texturing protective layer are not specifically limited, provided that the texturing protective layer can react with the texturing liquid and is dissolved in the texturing liquid. An optional material may be silicon dioxide, phosphosilicate glass, borosilicate glass, silicon nitride, or the like. The thickness needs to be set in combination of the texturing protective layer and a rate at which reaction with the texturing liquid disappears, to achieve a required duration difference. Texturing factors such as the compositions and the density of the texturing liquid, the angle between the thickness direction of the silicon substrate and the liquid surface of the texturing liquid, and the like are not specifically limited. The difference between the two texturing duration, the apex angle of the first textured structure, the apex angle of the second textured structure, and the like may be adjusted by adjusting texturing factors such as the compositions and the density of the texturing liquid, the angle between the thickness direction of the silicon substrate and the liquid surface of the texturing liquid, the material and the thickness of the texturing protective layer, and the like. This is not specifically limited.

For the manner of obliquely disposing the silicon substrate in the texturing liquid, the light-facing surface of the silicon substrate is closer to the liquid surface of the texturing liquid than the back surface at the two opposite positions in the thickness direction of the silicon substrate. On one hand, gas is generated by texturing reaction during texturing. When a distance between the light-facing surface of the silicon substrate and the liquid surface of the texturing liquid is smaller than a distance between the back surface of the silicon substrate and the liquid surface of the texturing liquid at the two opposite positions in the thickness direction of the silicon substrate, gas generated during texturing on the light-facing surface of the silicon substrate overflows from the liquid surface of the texturing liquid faster, and a rate of the texturing reaction is higher, so that the first textured structure and the second textured structure are easily obtained. On the other hand, the silicon substrate carries air when entering the texturing liquid. When the distance between the light-facing surface of the silicon substrate and the liquid surface of the texturing liquid is smaller than the distance between the back surface of the silicon substrate and the liquid surface of the texturing liquid at the two opposite positions in the thickness direction of the silicon substrate, air on the back surface of the silicon substrate is less easily vented. Therefore, a start time point of texturing reaction on the back surface of the silicon substrate is later than a start time point of texturing reaction on the light-facing surface of the silicon substrate, so that the first textured structure and the second textured structure are also easily obtained. The difference is particularly obvious when the surface of the silicon substrate is uneven. For example, for a back contact solar cell, a slot may exist on the back surface of the silicon substrate before texturing due to doping. The existence of the slot causes more air to be carried in the slot when the silicon substrate enters the texturing liquid, and gas generated during reaction is more easily retained in the slot. In addition, when the slot is narrower and deeper, duration for which the carried air and the gas generated during reaction are vented from the liquid surface of the texturing liquid may be longer, so that the first textured structure and the second textured structure are also easily obtained through preparation. For example, for an HPBC (hybrid passivated back contact solar cell) and a TBC (TOPCon back contact solar cell), a slot on a back surface of a silicon substrate in the TBC may be narrower. Therefore, duration for which air carried in the slot of the TBC when the silicon substrate enters texturing liquid and gas generated by reaction are vented from the texturing liquid may be longer, so that different textured surfaces on a front side and a back side are more easily obtained.

For the manner of obliquely disposing the silicon substrate in the texturing liquid, whether to dispose the texturing protective layer, the material and the thickness of the texturing protective layer, and the like are not specifically limited. Texturing factors such as the compositions and the density of the texturing liquid, the angle between the thickness direction of the silicon substrate and the liquid surface of the texturing liquid, and the like are not specifically limited. The difference between the two texturing duration, the apex angle of the first textured structure, the apex angle of the second textured structure, and the like may be adjusted by adjusting texturing factors such as the compositions and the density of the texturing liquid, the angle between the thickness direction of the silicon substrate and the liquid surface of the texturing liquid, the material and the thickness of the texturing protective layer, and the like. This is not specifically limited.

Step 103: Prepare a front-side passivation anti-reflection layer on a light-facing side of the silicon substrate, and prepare a back-side passivation anti-reflection layer on a back side of the silicon substrate.

The front-side passivation anti-reflection layer and the back-side passivation anti-reflection layer may be prepared in a manner such as deposition. This is not specifically limited.

In an embodiment, on the basis that the texturing duration of at least the part of the regions of the back surface of the silicon substrate is shorter than the texturing duration of the light-facing surface of the silicon substrate, a difference between the texturing duration of the light-facing surface of the silicon substrate and the texturing duration of at least the part of the regions of the back surface of the silicon substrate ranges from 30 seconds to 200 seconds. Morphologies of the first textured structure and the second textured structure that are obtained within the range of the difference of the duration both satisfy corresponding requirements on passivation and anti-reflection. The difference between the texturing duration is applicable to separately performing texturing, disposing the texturing protective layer, and obliquely disposing the silicon substrate. For example, in the manner of separately performing texturing and the manner of disposing the texturing protective layer, the difference between the texturing duration of the light-facing surface of the silicon substrate and the texturing duration of at least the part of the regions of the back surface of the silicon substrate may range from 50 seconds to 200 seconds. For the manner of obliquely disposing the silicon substrate, the manner of disposing the silicon substrate enables the first textured structure and the second textured structure to be more easily obtained. Therefore, in a case in which the manner of obliquely disposing the silicon substrate is included, the difference between the texturing duration of the light-facing surface of the silicon substrate and the texturing duration of at least the part of the regions of the back surface of the silicon substrate may be small within the range from 30 seconds to 200 seconds. However, in the case in which the manner of obliquely disposing the silicon substrate is included, due to different texturing factors such as whether to dispose the texturing protective layer, the material and the thickness of the texturing protective layer, the compositions and the density of the texturing liquid, the angle between the thickness direction of the silicon substrate and the liquid surface of the texturing liquid, and the like, the difference between the texturing duration of the light-facing surface of the silicon substrate and the texturing duration of at least the part of the regions of the back surface of the silicon substrate varies from 30 seconds to 200 seconds.

For example, for at least one of separately performing texturing, disposing the texturing protective layer, and obliquely disposing the silicon substrate, on the basis that the texturing duration of at least the part of the regions of the back surface of the silicon substrate is shorter than the texturing duration of the light-facing surface of the silicon substrate, the difference between the texturing duration of the light-facing surface of the silicon substrate and the texturing duration of at least the part of the regions of the back surface of the silicon substrate may be 30 seconds, 33 seconds, 40 seconds, 46 seconds, 50 seconds, 55 seconds, 60 seconds, 72 seconds, 89 seconds, 100 seconds, 111 seconds, 126 seconds, 125 seconds, 150 seconds, 175 seconds, 187 seconds, or 200 seconds.

It should be noted that, for the manner of obliquely disposing the silicon substrate, the difference between the texturing duration of the light-facing surface of the silicon substrate and the texturing duration of at least the part of the regions of the back surface of the silicon substrate may include the following two parts. One part is a difference between venting duration of air on the light-facing surface of the silicon substrate and venting duration of air in at least the part of the regions of the back surface of the silicon substrate when the air is carried when the silicon substrate enters the texturing liquid. The other part is a difference between texturing duration caused by different venting rates of reaction gas of texturing reaction on the light-facing surface of the silicon substrate and reaction gas of texturing reaction in at least the part of the regions of the back surface of the silicon substrate.

In an embodiment, for the manner of obliquely disposing the silicon substrate, the angle between the thickness direction of the silicon substrate and the liquid surface of the texturing liquid ranges from 3° to 7°. The apex angles of the first textured structure in the foregoing angle range and the apex angles of the second textured structure in the foregoing angle range are separately formed easily within the angle range. Under a same condition, a larger inclination angle indicates a larger impact on texturing on the front side and the back side and a larger difference between the textured surfaces on the front side and the back side. For example, for the manner of obliquely disposing the silicon substrate, the angle between the thickness direction of the silicon substrate and the liquid surface of the texturing liquid may be 3°, 3.1°, 3.7°, 3.92°, 4°, 4.2°, 4.5°, 5°, 5.6°, 5.9°, 6.3°, 6.5°, 6.9°, or 7°, so that a manner of forming an angle between the thickness direction of the silicon substrate and the liquid surface of the texturing liquid may be implemented by obliquely disposing a single silicon substrate, or may be implemented by overall obliquity of a tool carrying the silicon substrate, such as a large flower basket.

It should be noted that, for the manners of separately performing texturing and disposing the texturing protective layer, during texturing, the angle between the thickness direction of the silicon substrate and the liquid surface of the texturing liquid is not specifically limited. For example, the angle between the thickness direction of the silicon substrate and the liquid surface of the texturing liquid may be less than 3°, or the angle between the thickness direction of the silicon substrate and the liquid surface of the texturing liquid may range from 3° to 7°.

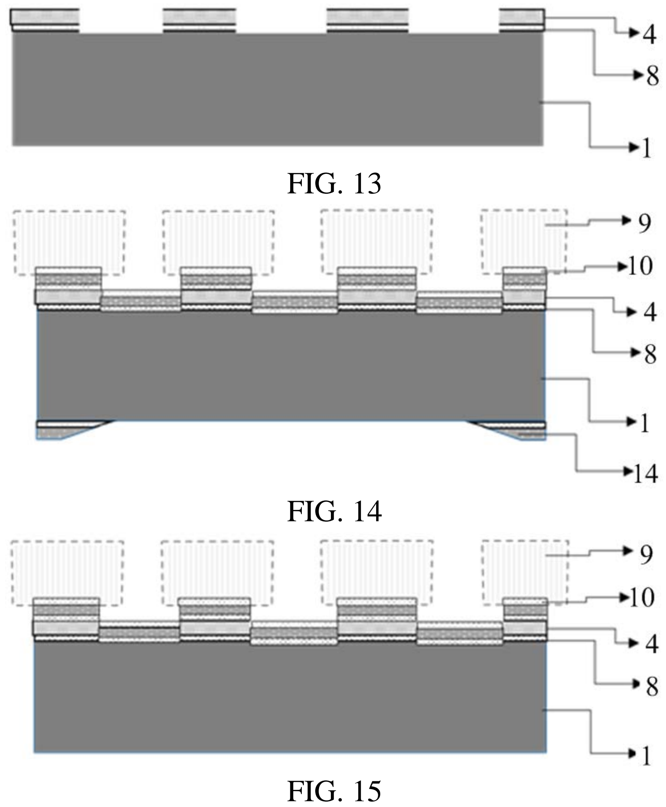

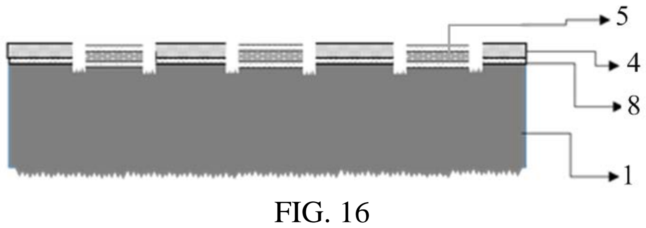

In an embodiment, before step 102, the method may further include: performing polishing processing on the silicon substrate, to form a smooth and clean surface. A manner such as alkali polishing may be used, and a specific polishing manner is not limited. After the polishing, referring to FIG. 11, an entire first conductive layer 4 is prepared on the back surface of the silicon substrate. Referring to FIG. 13, pattering processing is performed on parts that are at the first conductive layer 4 and that are located in the second region and the isolation region, to expose the second region and the isolation region. Referring to FIG. 14, second conductive layers are prepared in the second region, the isolation region, and the remaining of the first conductive layer 4. A conductivity type of the first conductive layer is different from a conductivity type of the second conductive layers. One of the conductivity types is an n-type, and the other is a p-type. Referring to FIG. 14, step 102 may include: performing laser processing on parts that are at the second conductive layer and that are located in the first region and the isolation region, to oxidize the parts that are at the second conductive layer and that are located in the first region and the isolation region into the texturing protective layer 10. The texturing protective layer 10 formed through laser and oxidation may be etched by the texturing liquid. Referring to FIG. 16, step 102 may include: performing texturing on the silicon substrate 1, to form the first textured structure on the light-facing surface of the silicon substrate 1, removing the texturing protective layer 10 by using the texturing liquid, to expose the isolation region and the first conductive layer, and then performing texturing on the isolation region by using the texturing liquid, to form the second textured structure in the isolation region on the back surface of the silicon substrate 1. The texturing protective layer 10 is etched, so that texturing duration of the isolation region on the back surface of the silicon substrate 1 can be reduced, to easily obtain the first textured structure and the second textured structure. The texturing liquid basically does not etch the exposed first conductive layer herein.

In an embodiment, in the laser processing, the laser includes one of nanosecond laser, picosecond laser, and femtosecond laser. The laser is easily obtained, and an extent to which the texturing protective layer 10 obtained by oxidizing the parts that are at the second conductive layer and that are located in the first region and the isolation region reduces the texturing duration of the isolation region on the back surface of the silicon substrate 1 is proper, so that any one of the first textured structure and the second textured structure is easily obtained.

In an embodiment, in the laser processing, a laser power ranges from 10 W (Watt) to 100 W. The laser power is proper, so that an extent to which the texturing protective layer 10 obtained through oxidation reduces the texturing duration of the isolation region on the back surface of the silicon substrate 1 is proper, and any one of the first textured structure and the second textured structure is easily obtained. In addition, the laser power is proper, and a laser damage is hardly introduced to the solar cell.

For example, in the laser processing, the laser power may be 10 W, 13 W, 18.2 W, 20 W, 25 W, 30 W, 34.2 W, 40 W, 50 W, 55 W, 63 W, 77 W, 89 W, or 100 W.

In an embodiment, in the laser processing, a diameter of a light spot of the laser ranges from 50 µm to 350 µm. The diameter of the light spot of the laser is proper, and the width of the formed isolation region also approximately ranges from 50 µm to 350 µm, so that not only an insulation and isolation effect of the first conductive layers 4 and the second conductive layers 5 is good, but also space in the back contact solar cell is not wasted.

For example, in the laser processing, the diameter of the light spot of the laser may be 50 µm, 54 µm, 63 µm, 77 µm, 89 µm, 100 µm, 144 µm, 200 µm, 231 µm, 250 µm, 272 µm, 281 µm, 300 µm, 322 µm, or 350 µm.

The present application is further described below with reference to specific embodiments.

### Embodiment

Step 1: Alkali polishing was performed on a monocrystalline silicon substrate 1 by using an alkali solution, to form a smooth and clean silicon surface. A back surface of the monocrystalline silicon substrate 1 includes first regions and second regions that are alternately distributed and isolated by isolation regions. A specific type of the alkali solution is not specifically limited, and may be, for example, selected from at least one of a solution of sodium hydroxide (NaOH) and a solution of potassium hydroxide (KOH).

Step 2: Referring to FIG. 11, deposition of an entire tunneling oxide layer 8 and an entire polysilicon layer was performed on the surface of the monocrystalline silicon substrate 1 after the alkali polishing.

Step 3: Doping was performed on the deposed polysilicon layer, to form first conductive layers 4 that are not limited to an acceptor and a donor such as boron and phosphorus.

Step 4: Referring to FIG. 12, laser mold-making was performed on the doped monocrystalline silicon substrate 1, where the laser mold-making was mainly to irradiate laser at positions of the second regions and the isolation regions, and the first conductive layers 4 at the positions at which the laser was irradiated was scattered.

Step 5: Referring to FIG. 13, surface corroding was performed on the silicon substrate 1 after the laser mold-making, where the positions at which the laser was irradiated were corroded, and a position at which the laser was not irradiated was not corroded. The regions at which the laser was irradiated was etched to expose the silicon substrate, in other words, in the first conductive layers 4, parts located in the second regions and the isolation regions were etched to expose the second region and the isolation region, and parts of the first conductive layers 4 that are located in the first regions were retained.

Step 6: Referring to FIG. 14, second conductive layers, which are not limited to an acceptor and a donor such as boron and phosphorus, were prepared on the back surface of the silicon substrate 1 after the corroding. A conductivity type of the first conductive layers is different from a conductivity type of the second conductive layers.

Step 7: Referring to FIG. 14, laser pattering processing was performed on the silicon substrate 1 on which the second conductive layers were prepared, where laser processing needed to be performed on a position at which an isolation region between a P region and an N region was to be prepared and the first regions, to form a weak texturing protective layer 10 having a function of blocking alkali corrosion. The laser may be nanosecond laser, picosecond laser, or femtosecond laser, a power of the laser may range from 10 W to 100 W, and a diameter of a light spot of the laser ranges from 50 µm to 350 µm.

Step 8: Referring to FIG. 15, wrap-around polysilicon 14 was removed from a light-facing surface of the silicon substrate 1 in a manner of chained acid etching or alkali etching, so that the light-facing surface of the silicon substrate 1 became the surface of the silicon substrate.

Step 9: Referring to FIG. 16, texturing and back-surface corroding were performed on the light-facing surface of the silicon substrate 1 after the processing in step 8, where an angle between a thickness direction of the silicon substrate and a liquid surface of texturing liquid was less than 3°, and texturing was performed on the entire light-facing surface of the silicon substrate 1, to form a first textured structure. The positions that are of the back surface and on which laser processing was performed in step 7 were first protected by the texturing protective layer 10 to avoid alkali corrosion within particular duration, so that different corroded duration of the light-facing surface and the back surface under a same texturing process were formed, and blocking duration of the back surface can be controlled within a particular range by using a laser process, to implement a corrosion duration difference ranging from 50 s to 200 s. When a morphology of the first textured structure is adjusted by using a distributed texturing method and an auxiliary additive on the light-facing surface, a textured structure with a large specific surface area is not formed in the isolation region on the back surface due to the protection of the texturing protective layer 10, but the second textured structure is formed, to protect overall passivation performance of the back surface. In step 9, parts that are at the second conductive layer and that are located in the first regions are also etched.

Step 10: A back-side passivation anti-reflection layer was formed on the first conductive layers and the second conductive layers, and a front-side passivation anti-reflection layer was formed on a light-facing side of the silicon substrate.

### Comparative example

In the comparative example, step 7 in the foregoing embodiment is not included. In step 9 in the comparative example, because there is no protection of a texturing protective layer, textured structures formed in isolation regions of a light-facing surface and a back surface are the same. Other steps in the comparative example are correspondingly the same as other steps of the embodiment.

In a same test environment, electricity performance of the solar cells in the embodiment and the comparative example are tested. For a test result, refer to the following table.

**Table of comparison between the electricity performance of the solar cells in the embodiment and the comparative example**

| Group | Eta (%) | Voc (mV) | Isc (A) | FF (%) |
|---|---|---|---|---|
| Comparative example | 24.943 | 731.4 | 14.004 | 81.51 |
| Embodiment | 24.968 | 732.0 | 14.003 | 81.53 |

In the foregoing table, Eta refers to a photoelectric conversion efficiency, Voc refers to an open-circuit voltage, Isc refers to a short-circuit current, and FF refers to a conversion factor. It can be learned from the foregoing table that a photoelectric conversion efficiency, an open-circuit voltage, a short-circuit current, and a conversion factor of the solar cell in the embodiment are all higher than those of the solar cell in the comparative example. A main reason lies in that, in this embodiment, the morphology of the first textured structure on the light-facing surface of the silicon substrate 1 and a morphology of the second textured structure in the isolation region on the back surface are adjusted, so that the first textured structure is sharper, the first textured structure has a larger specific surface area, in other words, the light-facing surface of the silicon substrate has a lower reflectivity and a better light trapping effect. Therefore, the short-circuit current can be improved, and the photoelectric conversion efficiency of the solar cell is finally improved. In addition, apex angles of the second textured structure on the back surface of the silicon substrate are larger, that is, the second textured structure on the back surface of the silicon substrate is flatter, to help prepare to obtain the thick back-side passivation anti-reflection layer, thereby achieving a good passivation effect.

It needs to be noted that, for ease of description, the method embodiments are described as a series of action combinations. However, a person skilled in the art should know that the embodiments of the present application are not limited to the described order of actions, because some steps may be performed in another order or simultaneously according to the embodiments of the present application. In addition, a person skilled in the art should also learn that, the embodiments described in this specification are all optional embodiments, and actions involved are not necessarily all required in the embodiments of the present application.

It needs to be noted that, in this specification, terms "include", "comprise", or any other variant thereof are intended to cover non-exclusive inclusion, so that a process, method, product, or apparatus that includes a series of elements includes not only the elements, but also another element not expressly listed, or an element inherent to such a process, method, product, or apparatus. An element defined by a statement "includes a..." does not exclude, without more limitations, existence of another same element in a process, method, product, or apparatus that includes the element.

According to the foregoing descriptions of the implementations, a person skilled in the art may clearly understand that the methods in the embodiments may be implemented by using software plus a necessary universal hardware platform, and certainly may alternatively be implemented by hardware. However, in many cases, the former is a better implementation. Based on such an understanding, the technical solutions of the present application essentially, or the part contributing to the related art may be implemented in a form of a software product. The computer software product is stored in a storage medium (such as a read-only memory (ROM)/random access memory (RAM), a magnetic disk, or an optical disc) and includes a plurality of instructions for instructing a terminal (which may be a mobile phone, a computer, a server, an air conditioner, a network device, or the like) to perform the methods described in the embodiments of the present application.

The foregoing describes embodiments of the present application with reference to the accompanying drawings. However, the present application is not limited to the foregoing specific implementations. The foregoing specific implementations are merely examples, but are not limitative. Inspired by the present application, a person of ordinary skill in the art may further make modifications without departing from the purposes of the present application and the protection scope of the claims, and all the modifications shall fall within the protection of the present application.

## Claims

1. A solar cell, comprising a silicon substrate, a front-side passivation anti-reflection layer located on a light-facing side of the silicon substrate, and a back-side passivation anti-reflection layer located on a back side of the silicon substrate, wherein:
the silicon substrate comprises a light-facing surface and a back surface;
the light-facing surface of the silicon substrate comprises a first textured structure, wherein at least a part of regions of the back surface of the silicon substrate comprises a second textured structure; and
apex angles of the second textured structure are greater than apex angles of the first textured structure.

2. The solar cell according to claim 1, wherein the apex angles of the second textured structure are greater than or equal to 79°, and the apex angles of the first textured structure are less than 79°.

3. The solar cell according to claim 1, wherein an average apex angle of the second textured structure is greater than or equal to 85°, and an average apex angle of the first textured structure is less than 75°.

4. The solar cell according to claim 1, wherein an absolute value of a largest difference between apex angles of adjacent first textured structures on the light-facing surface of the silicon substrate is greater than an absolute value of a largest difference between apex angles of adjacent second textured structures on the back surface of the silicon substrate.

5. The solar cell according to claim 1, wherein the first textured structure comprises a plurality of first quasi-pyramid structures, and each of the first quasi-pyramid structures comprises a pyramid surface and a pyramid vertex, and wherein the second textured structure comprises a plurality of second quasi-pyramid structures, and each of the second quasi-pyramid structures comprises a pyramid surface and a pyramid vertex.

6. The solar cell according to claim 5, wherein a surface fluctuation of the pyramid surface of the first quasi-pyramid structure is greater than a surface fluctuation of the pyramid surface of the second quasi-pyramid structure; or
a roughness of the pyramid surface of the first quasi-pyramid structure is greater than a roughness of the pyramid surface of the second quasi-pyramid structure.

7. The solar cell according to claim 5, wherein a surface fluctuation of a first sub-pyramid surface that is close to the pyramid vertex of the first quasi-pyramid structure and that is on the pyramid surface of the first quasi-pyramid structure is greater than a surface fluctuation of a second sub-pyramid surface that is close to the pyramid vertex of the second quasi-pyramid structure and that is on the pyramid surface of the second quasi-pyramid structure; or
a roughness of the first sub-pyramid surface is greater than a roughness of the second sub-pyramid surface.

8. The solar cell according to claim 7, wherein the first quasi-pyramid structure comprises a lower portion and an upper portion, the lower portion is a portion away from the pyramid vertex in the first quasi-pyramid structure, a height of the lower portion is at least 1/10 of a height of the first quasi-pyramid structure, and the first sub-pyramid surface is a region corresponding to the upper portion on the pyramid surface of the first quasi-pyramid structure; and
wherein the second quasi-pyramid structure comprises a lower portion and an upper portion, the lower portion is a portion away from the pyramid vertex in the second quasi-pyramid structure, a height of the lower portion is at least 1/10 of a height of the second quasi-pyramid structure, and the second sub-pyramid surface is a region corresponding to the upper portion on the pyramid surface of the second quasi-pyramid structure.

9. The solar cell according to claim 5, wherein:
the first quasi-pyramid structure further comprises a bottom outline away from the pyramid vertex, and a width of the first quasi-pyramid structure is a maximum inner size of the bottom outline of the first quasi-pyramid structure;
the second quasi-pyramid structure further comprises a bottom outline away from the pyramid vertex, and a width of the second quasi-pyramid structure is a maximum inner size of the bottom outline of the second quasi-pyramid structure; and
a ratio of a height of the first quasi-pyramid structure to the width of the first quasi-pyramid structure is greater than a ratio of a height of the second quasi-pyramid structure to the width of the second quasi-pyramid structure.

10. The solar cell according to claim 5, wherein the pyramid surface of the first quasi-pyramid structure and the pyramid surface of the second quasi-pyramid structure have branched textures, and a quantity of branched textures on the pyramid surface of the first quasi-pyramid structure is greater than a quantity of branched textures on the pyramid surface of the second quasi-pyramid structure; or
the pyramid surface of the first quasi-pyramid structure has branched textures, and the pyramid surface of the second quasi-pyramid structure does not have branched textures.

11. The solar cell according to any one of claims 1 to 10, wherein the front-side passivation anti-reflection layer comprises a first part located in the first textured structure, and the back-side passivation anti-reflection layer comprises a second part located in the second textured structure; and
a thickness of the first part is less than a thickness of the second part.

12. The solar cell according to any one of claims 1 to 10, wherein the back surface of the silicon substrate has a non-textured structure, and the back-side passivation anti-reflection layer comprises a second part located in the second textured structure and a third part located in the non-textured structure; and
wherein a thickness of the second part is less than a thickness of the third part.

13. The solar cell according to any one of claims 1 to 10, wherein the front-side passivation anti-reflection layer comprises a first part located in the first textured structure, the back surface of the silicon substrate has a non-textured structure, and the back-side passivation anti-reflection layer comprises a second part located in the second textured structure and a third part located in the non-textured structure; and
wherein a thickness of the first part is smaller than a thickness of the second part, and the thickness of the second part is smaller than a thickness of the third part.

14. The solar cell according to any one of claims 5 to 10, wherein:
the front-side passivation anti-reflection layer comprises a first part located in the first textured structure, and the back-side passivation anti-reflection layer comprises a second part located in the second textured structure;
an unevenness of a thickness of the first part is greater than an unevenness of a thickness of the second part;
the unevenness of the thickness of the first part is: in parts located in a same first quasi-pyramid structure at the front-side passivation anti-reflection layer, an absolute value of a difference between two thicknesses at two positions in a same direction toward a pyramid vertex of the first quasi-pyramid structure divided by a sum of the two thicknesses; and
the unevenness of the thickness of the second part is: in parts located in a same second quasi-pyramid structure at the back-side passivation anti-reflection layer, an absolute value of a difference between two thicknesses at two positions in a same direction toward a pyramid vertex of the second quasi-pyramid structure divided by a sum of the two thicknesses.

15. The solar cell according to any one of claims 1 to 10, wherein a difference between a thickness of a part located in the second textured structure at the back-side passivation anti-reflection layer and a thickness of the front-side passivation anti-reflection layer is greater than or equal to 15 nm and less than or equal to 50 nm at two opposite positions in a thickness direction of the silicon substrate.

16. The solar cell according to any one of claims 1 to 10, wherein:
the back surface of the silicon substrate comprises first regions and second regions that are alternately distributed and isolated by isolation regions;
the solar cell further comprises first conductive layers located in the first regions and second conductive layers located in the second regions, and a conductivity type of the first conductive layers is different from a conductivity type of the second conductive layers; and
at least one of the first regions, the second regions, and the isolation regions have the second textured structure on the back surface of the silicon substrate.

17. The solar cell according to any one of claims 1 to 10, wherein:
the back surface of the silicon substrate comprises first regions and second regions that are alternately distributed;
the solar cell further comprises first conductive layers located in the first regions, wherein first conductive elements are doped at the first conductive layers, and second conductive elements are doped in at least a part of the second regions;
a conductivity type of the first conductive elements is different from a conductivity type of the second conductive elements; and
intersections of the second regions and the first regions have the second textured structure.

18. The solar cell according to any one of claims 1 to 10, wherein the solar cell further comprises:
a first conductive layer located between the silicon substrate and the front-side passivation anti-reflection layer; and
a second conductive layer located between the silicon substrate and the back-side passivation anti-reflection layer; and a conductivity type of the first conductive layer is different from a conductivity type of the second conductive layer; and
wherein the back surface of the silicon substrate has the second textured structure.

19. A photovoltaic module, comprising a plurality of solar cells according to any one of claims 1 to 18.

20. A preparation method for a solar cell, wherein the method comprises:
providing a silicon substrate, wherein the silicon substrate comprises a light-facing surface and a back surface;
performing texturing on the silicon substrate to form a first textured structure on the light-facing surface of the silicon substrate and a second textured structure in at least a part of regions of the back surface of the silicon substrate, wherein apex angles of the second textured structure are greater than apex angles of the first textured structure;
preparing a front-side passivation anti-reflection layer on a light-facing side of the silicon substrate; and
preparing a back-side passivation anti-reflection layer on a back side of the silicon substrate.

21. The preparation method for a solar cell according to claim 20, wherein the performing texturing on the silicon substrate comprises:
separately performing texturing on the light-facing surface and the back surface of the silicon substrate, to enable texturing duration of at least the part of the regions of the back surface of the silicon substrate to be shorter than texturing duration of the light-facing surface of the silicon substrate; and/or
disposing a texturing protective layer in at least the part of the regions of the back surface of the silicon substrate, and performing texturing on the silicon substrate, wherein texturing duration of at least the part of the regions of the back surface of the silicon substrate is shorter than texturing duration of the light-facing surface of the silicon substrate under a blocking effect of the texturing protective layer; and/or
obliquely disposing the silicon substrate in texturing liquid, wherein the light-facing surface of the silicon substrate is closer to a liquid surface of the texturing liquid than the back surface at two opposite positions in a thickness direction of the silicon substrate, and performing texturing on the silicon substrate.

22. The preparation method for a solar cell according to claim 21, wherein a difference between the texturing duration of the light-facing surface of the silicon substrate and the texturing duration of at least the part of the regions of the back surface of the silicon substrate ranges from 30 seconds to 200 seconds.

23. The preparation method for a solar cell according to claim 21 or 22, wherein the back surface of the silicon substrate comprises first regions and second regions that are alternately distributed and isolated by isolation regions; and before the disposing a texturing protective layer in at least the part of the regions of the back surface of the silicon substrate, the method further comprises:
performing polishing processing on the silicon substrate;
preparing a first conductive layer on the back surface of the silicon substrate;
performing pattering processing on parts that are at the first conductive layer and that are located in the second region and the isolation region, to expose the second region and the isolation region; and
preparing second conductive layers in the second region, the isolation region, and the remaining of the first conductive layer, wherein a conductivity type of the first conductive layer is different from a conductivity type of the second conductive layers;
the disposing a texturing protective layer in at least the part of the regions of the back surface of the silicon substrate comprises:
performing laser processing on parts that are at the second conductive layer and that are located in the first region and the isolation region, to oxidize the parts that are at the second conductive layer and that are located in the first region and the isolation region into the texturing protective layer; and
the performing texturing on the silicon substrate, wherein texturing duration of at least the part of the regions of the back surface of the silicon substrate is shorter than texturing duration of the light-facing surface of the silicon substrate under a blocking effect of the texturing protective layer, to form a first textured structure on the light-facing surface of the silicon substrate and a second textured structure in at least a part of regions of the back surface of the silicon substrate comprises:
performing texturing on the silicon substrate, to form the first textured structure on the light-facing surface of the silicon substrate, removing the texturing protective layer by using the texturing liquid, to expose the isolation region and the first conductive layer, and then performing texturing on the isolation region by using the texturing liquid, to form the second textured structure in the isolation region on the back surface of the silicon substrate.

24. The preparation method for a solar cell according to claim 21 or 22, wherein
the silicon substrate is disposed in the texturing liquid, and an angle between the thickness direction of the silicon substrate and the liquid surface of the texturing liquid ranges from 3° to 7°.
